# EUROPEAN PATENT APPLICATION

(11) **EP 2 136 552 A1**
(43) Date of publication of application: **23.12.2009**
(21) Application number: 08738568.8
(22) Date of filing: 11.04.2008
(51) Int. Cl.: H04N 5/335, H01L 27/14, H04N 5/225

(54) **SOLID-STATE IMAGING DEVICE AND METHOD FOR MANUFACTURING THE SAME**

(30) Priority: 13.04.2007 JP 2007106426; 13.04.2007 JP 2007106427; 13.04.2007 JP 2007106428; 13.04.2007 JP 2007106429; 18.06.2007 JP 2007160067
(71) Applicant: Panasonic Corporation, Kadoma-shi Osaka 571-8501 (JP)
(72) Inventor: NAKAGIRI, Yasushi, Osaka-shi, Osaka 540-6207 (JP); MIKAMI, Masahiko, Osaka-shi, Osaka 540-6207 (JP); HARAZONO, Fumikazu, Osaka-shi, Osaka 540-6207 (JP)
(74) Representative: Grünecker, Kinkeldey, Stockmair & Schwanhäusser Anwaltssozietät
(86) International application number: PCT/JP2008/000962
(87) International publication number: WO 2008/132802

(57) **Abstract**

A solid-state imaging apparatus of the invention intends to provide a thin solid-state imaging apparatus having high rigidity, high reliability and an improvement in accuracy using a flexible wiring board, and is a solid-state imaging apparatus comprising a flexible wiring board, a reinforcing plate, a solid-state imaging element substrate, a translucent member, an optical lens and a lens cabinet, and the flexible substrate and the reinforcing plate have the same outer shape and are laminated and integrated, and a positioning hole for being commonly used from the front and the back as a reference in the case of placing the lens cabinet and the case of placing the solid-state imaging element substrate is formed in the reinforcing plate, and the translucent member is placed so as to close an opening part, and the solid-state imaging element substrate and the lens cabinet are oppositely placed in a state of sandwiching an opening part using the positioning hole as a common reference.

## Description

### <Technical Field>

The present invention relates to a solid-state imaging apparatus and a manufacturing method thereof, and particularly to a miniature solid-state imaging apparatus formed using a solid-state imaging element of a monitoring camera, a medical camera, a vehicle-mounted camera, an information communication terminal camera, etc., and a manufacturing method of the solid-state imaging apparatus.

### <Background Art>

In recent years, demand for a miniature camera increases rapidly in a mobile telephone, a vehicle-mounted component, etc. A solid-state imaging apparatus for outputting an image inputted through an optical system such as a lens as an electrical signal by a solid-state imaging element is used in this kind of miniature camera. Then, with high performance and miniaturization of this imaging apparatus, the camera becomes smaller and use in each field increases and the market as a video input apparatus is expanded. In an imaging apparatus using a conventional semiconductor imaging element, components such as an LSI in which a lens, a semiconductor imaging element, its driving circuit and a signal processing circuit, etc. are installed are respectively formed in a cabinet or a structural body and these are combined. A mounting structure by such a combination was formed by installing each of the elements on a printed substrate on a flat plate. However, a desire for thinning with respect to an individual device is increasing year after year from a desire for further thinning of a mobile telephone etc. and in order to respond to its desire, an attempt to form a thinner imaging apparatus has been made by using a flexible wiring board or directly mounting an IC in a translucent member in a flip chip manner.

For example, a photoelectric converter in which a translucent member and a photoelectric conversion element are oppositely arranged with a flexible wiring board sandwiched therebetween is disclosed in Patent Reference 1.

A view disclosed in Patent Reference 1 is shown in Fig. 45. A translucent member 101 is glued to a flexible wiring board 102 through an adhesive 103. In the flexible wiring board 102, a metal wiring pattern 105 is wired to a resin film 104 and an opening part 106 is opened. The translucent member 101 and an imaging element 112 are oppositely placed with the opening part 106 sandwiched therebetween. A bump 113 is present in an electrode pad 117 of the solid-state imaging element 112 in which a microlens 115 is formed in an imaging area and is electrically connected to the metal wiring pattern 105 of the flexible substrate 102 through an anisotropic conductive film 111. Further, an adhesive strength of the solid-state imaging element 112 is reinforced by a sealing resin 116.

A structure using a reinforcing plate and a flexible wiring board in order to adjust an optical axis without being influenced by flexibility of a flexible substrate and ensure a strength is disclosed in Patent References 2, 3, 4. A structure in which a wiring pattern is directly formed using a translucent member as a substrate and an IC is mounted in a flip chip manner is disclosed in Patent Reference 5.
Patent Reference 1: Japanese Patent No.3207319
Patent Reference 2: JP-A-2001-78064
Patent Reference 3: JP-A-2005-278035
Patent Reference 4: JP-A-2006-20014
Patent Reference 5: JP-A-2001-203913

### <Disclosure of the Invention>

### <Problems that the Invention is to Solve>

However, in the imaging apparatus shown in Patent Reference 1, a translucent member and a photoelectric conversion element are held by only a flexible wiring board, so that rigidity cannot be kept. As a result of this, there were problems that trouble occurs in electrical connection or an optical axis deviates in the case of being installed in a mobile telephone etc. which require high impact durability or pressure durability.

Hence, in the imaging apparatus shown in Patent References 2, 3, 4, a method for increasing optical axis adjustment accuracy or ensuring rigidity using a reinforcing plate is adopted.

In Patent Reference 2, a reinforcing plate is stuck on the side of a translucent member of a flexible wiring board so as to support a lens cabinet. A size of the reinforcing plate is about the same size as the lens cabinet, and a flexible substrate is sandwiched between a surface of an imaging element and a mirror tube which is pasted on the periphery of an opening part of the flexible substrate and disposes an end face perpendicular to an optical axis. As a result of that, it is shown that an optical axis of the imaging element can easily be matched with an optical axis perpendicular to the end face of the mirror tube using the fact that both surfaces of the flexible substrate are parallel. However, in this case, a deviation tends to occur in the optical axis of an optical system or the imaging element resulting from flexibility of the flexible substrate and attention is needed so as not to come under this influence and workability reduces and also it is lacking in flexibility of a work step including a holding jig. Also, in pasting the reinforcing plate on the opening part, it is necessary to paste with high accuracy in order to ensure an imaging area and attention is needed so as not to cause a decrease in accuracy of the optical axis. This is because in variations in thickness at the time of sticking the reinforcing plate, its parallelism varies depending on variations in thickness of the reinforcing plate and an adhesive layer in addition to the flexible substrate itself (constructional members such as a base film, copper foil, an adhesive layer or a cover film). In order to suppress the variations, a problem of increasing a cost of a component is also had. Thus, there were the problems in reduction in cost or workability.

Also, in Patent Reference 3, a reinforcing plate is stuck on the side of an imaging element of a flexible wiring board and the reinforcing plate is formed smaller than an outer shape of the flexible wiring board. As a result of that, the imaging element can be mounted in the flexible wiring board and has a structure in which the periphery of a light receiving part of the imaging element is covered with the flexible wiring board. Further, an engaging hole for positioning of a lens cabinet is formed in a place in which the reinforcing plate overlaps with the flexible wiring board. In this case, there was a problem in position accuracy by flexibility of the flexible wiring board since the lens cabinet is further pushed on the flexible wiring board in addition to difficulty in aligning and sticking the reinforcing plate in a manner similar to Patent Reference 2 described above.

In Patent Reference 4, a reinforcing plate is stuck on the side of a translucent member of a flexible wiring board. High rigidity and a stable position of a lens cabinet are obtained by fixing the lens cabinet and the translucent member as a window material to the reinforcing plate. However, as described in Patent Reference 2, it was difficult to stick the reinforcing plate on a flexible substrate with high accuracy and there was also a problem in aligning an optical axis of an imaging element with a lens with high accuracy.

Also, in the imaging apparatus shown in Patent Reference 5, a wiring pattern is directly formed in a translucent substrate and glass is mainly used as the translucent substrate in order to form a pattern or a film. Since the optical glass is a hard and brittle material, when the glass is constructed thinly, a crack tends to occur and a yield at the time of manufacture is not good. As a result of this, an increase in cost is caused. In reverse, as a result of using the translucent substrate having a certain level of thickness in order to ensure a strength, it becomes a factor in inhibiting thinning. Even when the translucent substrate is constructed of a resin, a problem that resistance to the strength cannot be ensured is had.

The invention has been implemented in view of the actual circumstances described above, and an object of the invention is to provide a solid-state imaging apparatus in which it is easy to thin the solid-state imaging apparatus and assembly can be done with good workability and high rigidity and high accuracy of alignment of an optical axis can be obtained. Also, a solid-state imaging apparatus capable of miniaturizing a mobile telephone etc. can be provided.

Also, an object of the invention is to reduce a step and improve freedom of design and improve a yield.

### <Means for Solving the Problems>

A solid-state imaging apparatus of the invention comprises a laminated substrate constructed of a flexible wiring board having an opening part and a reinforcing plate laminated and integrated with the flexible wiring board, a translucent member placed in the side of the reinforcing plate of the laminated substrate so as to close an opening part, and a solid-state imaging element substrate placed in the side of the flexible wiring board of the laminated substrate, and is **characterized in that** the reinforcing plate comprises a reference hole for solid-state imaging element substrate placement and the reinforcing plate is also exposed to the side of the flexible wiring board in the peripheral edge of the reference hole and a solid-state imaging element substrate and a translucent member are arranged on both surfaces of the laminated substrate using the reference hole as a common reference.

By the configuration described above, a flexible wiring board and a reinforcing plate have the same outer shape dimension and form a laminated structure, and a reference hole in the case of installing a translucent member (or an optical lens) and a solid-state imaging element substrate is formed and a surface of the reinforcing plate is exposed to the side of the flexible wiring board in the periphery of the reference hole and the solid-state imaging element substrate and the translucent member can be placed using commonly its reference hole from the front and the back, with the result that it is easy to thin a solid-state imaging apparatus and assembly can be done with good workability, and high rigidity and high accuracy of alignment of an optical axis can be obtained. As a result of that, an excellent solid-state imaging apparatus capable of miniaturizing a mobile telephone etc. can be provided. The solid-state imaging element substrate herein refers to a substrate in which a solid-state imaging element is formed on a semiconductor substrate such as a silicon substrate, mainly a substrate divided into individual chips. Also, the reference hole includes the so-called notched part whose part is communicated to the outside as well as the so-called positioning hole whose peripheral edge is surrounded by a wall. Further, an outer shape, a wiring pattern, etc. using the reference hole as a reference may be used in alignment indirectly.

### <Advantage of the Invention>

According to the invention, a solid-state imaging apparatus can be thinned and high rigidity and an improvement in position accuracy can be achieved simply and the solid-state imaging apparatus with high reliability can be obtained.

Also, by using a manufacturing method of the solid-state imaging apparatus of the invention, the solid-state imaging apparatus with good controllability, high accuracy and high reliability can be manufactured easily in the case of thinning the solid-state imaging apparatus. As a result of that, a portable terminal apparatus can also be thinned.

### <Brief Description of the Drawings>

Fig. 1 is an exploded perspective view of a solid-state imaging apparatus of a first embodiment.
Fig. 2 is a top view of a flexible wiring board used in the solid-state imaging apparatus of the first embodiment.
Fig. 3 is an exploded perspective view of the solid-state imaging apparatus of the first embodiment.
Fig. 4 is a perspective view of the solid-state imaging apparatus of the first embodiment.
Fig. 5 is a perspective view of the solid-state imaging apparatus of the first embodiment.
Fig. 6 is a sectional view of a solid-state imaging apparatus showing a manufacturing method of the solid-state imaging apparatus of a second embodiment.
Fig. 7 is a sectional view of the solid-state imaging apparatus showing the manufacturing method of the solid-state imaging apparatus of the second embodiment.
Fig. 8 is an exploded perspective view of a solid-state imaging apparatus of a third embodiment.
Fig. 9 is a top view of a flexible wiring board used in the solid-state imaging apparatus of the third embodiment.
Fig. 10 is an exploded perspective view of the solid-state imaging apparatus of the third embodiment.
Fig. 11 is a perspective view of the solid-state imaging apparatus of the third embodiment.
Fig. 12 is a perspective view of the solid-state imaging apparatus of the third embodiment.
Fig. 13 is a sectional view of a solid-state imaging apparatus showing a manufacturing method of the solid-state imaging apparatus of a fourth embodiment.
Fig. 14 is an exploded perspective view of a solid-state imaging apparatus of a fifth embodiment.
Fig. 15 is a top view of a flexible wiring board used in the solid-state imaging apparatus of the fifth embodiment.
Fig. 16 is an exploded perspective view of the solid-state imaging apparatus of the fifth embodiment.
Fig. 17 is a perspective view of the solid-state imaging apparatus of the fifth embodiment.
Fig. 18 is a perspective view of the solid-state imaging apparatus of the fifth embodiment.
Fig. 19 is a sectional view of a solid-state imaging apparatus showing a manufacturing method of the solid-state imaging apparatus of a sixth embodiment.
Fig. 20 is an exploded perspective view of a solid-state imaging apparatus of a seventh embodiment.
Fig. 21 is an exploded perspective view of the solid-state imaging apparatus of the seventh embodiment.
Fig. 22 is an assembly perspective view of the solid-state imaging apparatus of the seventh embodiment.
Fig. 23 is a plan view of a solid-state imaging apparatus of an eighth embodiment.
Fig. 24 is a plan view of a solid-state imaging apparatus of a ninth embodiment.
Fig. 25 is a perspective view of the solid-state imaging apparatus of the ninth embodiment.
Fig. 26 is a plan view of a solid-state imaging apparatus of a tenth embodiment.
Fig. 27 is a perspective view of the solid-state imaging apparatus of the tenth embodiment.
Fig. 28 is a sectional view showing a manufacturing method of a solid-state imaging apparatus of a twelfth embodiment.
Fig. 29 is a sectional view showing a manufacturing method of a solid-state imaging apparatus of a thirteenth embodiment.
Fig. 30 is a sectional view showing a manufacturing method of a solid-state imaging apparatus of a fourteenth embodiment.
Fig. 31 is an exploded perspective view of a solid-state imaging apparatus of a fifteenth embodiment.
Fig. 32 is a sectional view of the solid-state imaging apparatus of the fifteenth embodiment.
Fig. 33 is a top view of a flexible wiring board used in the solid-state imaging apparatus of the fifteenth embodiment.
Fig. 34 is an exploded perspective view of the solid-state imaging apparatus of the fifteenth embodiment.
Fig. 35 is a perspective view of the solid-state imaging apparatus of the fifteenth embodiment.
Fig. 36 is a perspective view of the solid-state imaging apparatus of the fifteenth embodiment.
Fig. 37 is a sectional view of a solid-state imaging apparatus showing a manufacturing method of the solid-state imaging apparatus of a sixteenth embodiment.
Fig. 38 is a sectional view of a solid-state imaging apparatus showing a manufacturing method of the solid-state imaging apparatus of a seventeenth embodiment.
Fig. 39 is a sectional view of a solid-state imaging apparatus showing a manufacturing method of the solid-state imaging apparatus of an eighteenth embodiment.
Fig. 40 is a sectional view of a solid-state imaging apparatus showing a manufacturing method of the solid-state imaging apparatus of a nineteenth embodiment.

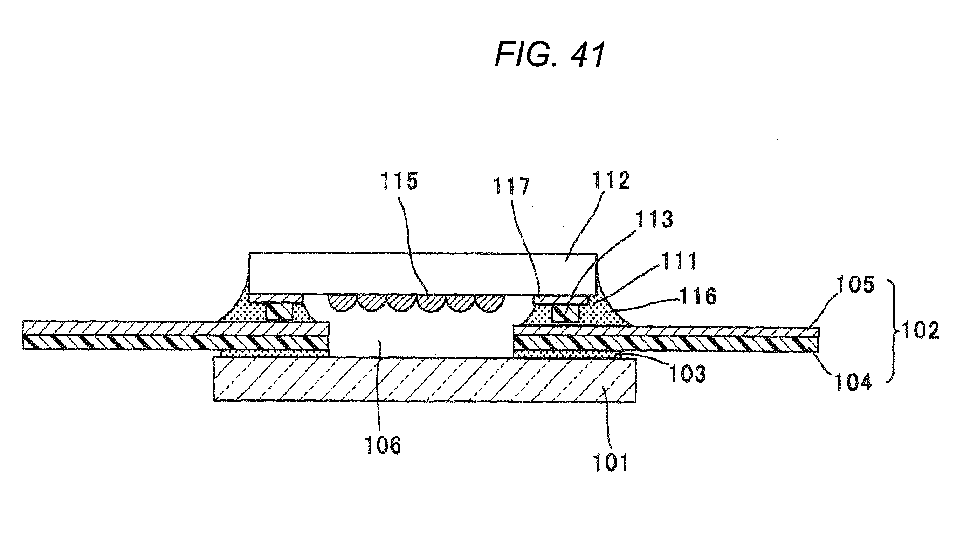

Fig. 41 is a sectional view of a conventional solid-state imaging apparatus.

### <Description of Reference Numerals and Signs>

- 1: Flexible wiring board
- 1a: Film base substance
- 1 b: Metal wiring pattern
- 2: Reinforcing plate
- 3: Reference notched part
- 4,6,8: Exposed part of reinforcing plate
- 5: Reference hole
- 7: Opening part
- 9: Sealing resin
- 10: Solid-state imaging element substrate
- 10b: Bump
- 10c: Conductive adhesive
- 11: Chip component
- 12: Connector
- 13: Step part
- 14: Translucent member
- 15: Optical lens
- 16: Lens cabinet
- 17: Reference protrusion part
- 18: Molded resin
- 19: Molded resin notched part
- 20: Wiring cable

### <Best Mode for Carrying Out the Invention>

Embodiments according to the invention will hereinafter be described in detail with reference to the drawings.

A basic structure of mounting will be described in first and second embodiments.

### (First embodiment)

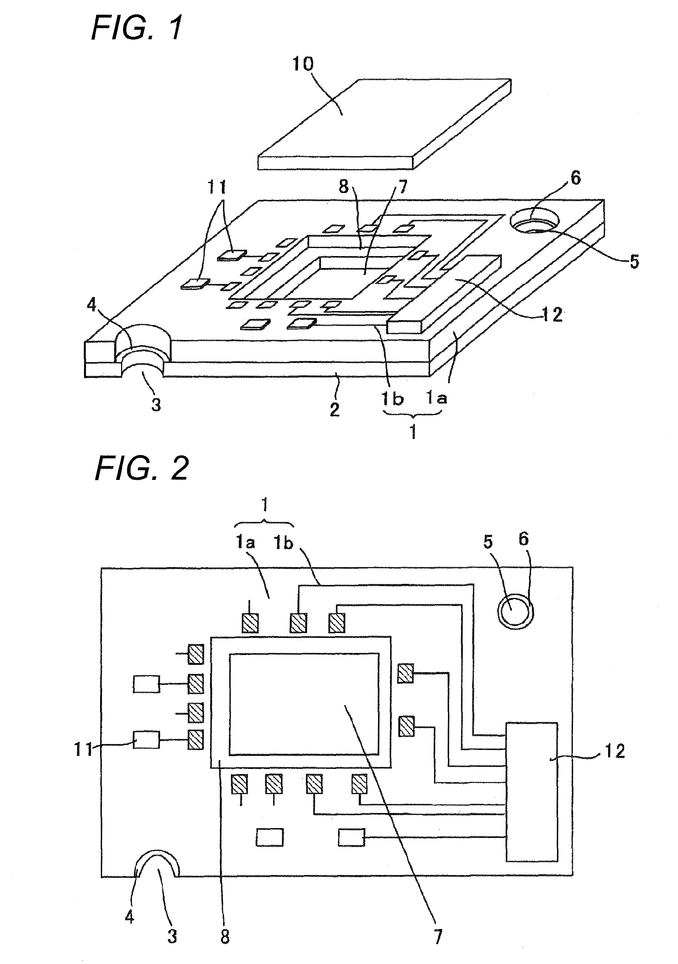

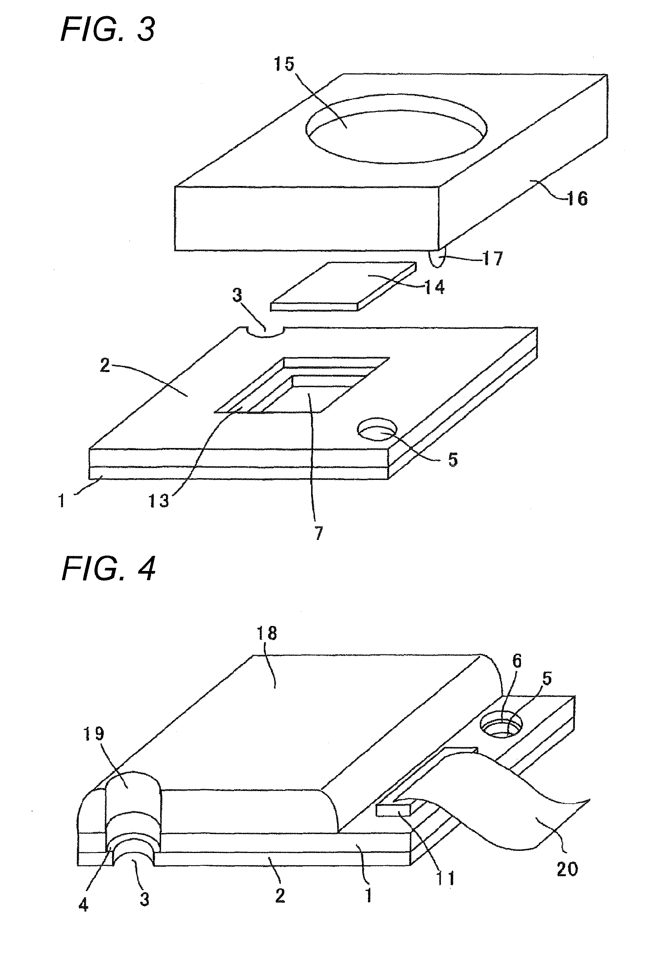

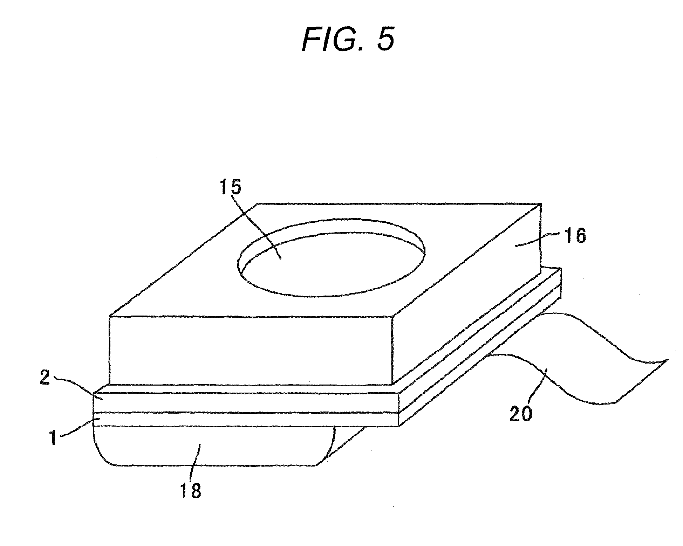

Fig. 1 is an exploded perspective view of a solid-state imaging apparatus of a first embodiment. Fig. 2 is a top view of a flexible wiring board used in the solid-state imaging apparatus of the first embodiment, and Fig. 3 is an exploded perspective view of the solid-state imaging apparatus of the first embodiment, and Fig. 4 is a perspective view of the solid-state imaging apparatus of the first embodiment, and Fig. 5 is a perspective view of the solid-state imaging apparatus of the first embodiment.

As shown in Figs. 1 and 5, this solid-state imaging apparatus comprises a laminated substrate constructed of a flexible wiring board 1 having an opening part and a reinforcing plate 2 laminated and integrated with this flexible wiring board 1, an optical lens 15 and a translucent member 14 placed in the side of the reinforcing plate 2 of this laminated substrate so as to close the opening part, and a solid-state imaging element substrate 10 placed in the side of the flexible wiring board 1 of this laminated substrate, and this reinforcing plate 2 comprises a positioning hole 5 and a notched part 3 as reference holes for placement of the solid-state imaging element substrate, and the reinforcing plate 2 is also exposed to the side of the flexible wiring board 1 in the peripheral edges of this notched part 3 and the positioning hole 5, and the solid-state imaging element substrate, the translucent member 14 and the optical lens 15 (a lens cabinet 16) are arranged on both surfaces of the laminated substrate using these two reference holes as a common reference.

In the embodiment, the flexible wiring board 1 and the reinforcing plate 2 with the same size and outer shape are laminated and pasted and thereby are integrated. In the flexible wiring board 1 of this case, a polyimide resin film with a thickness of 25 µm was used as a film base substance (base film) 1 a and a SUS plate with a thickness of 150 µm was used in the reinforcing plate 2. Then, the notched part 3 as the reference hole is formed in the reinforcing plate 2 and an exposed part 4 of the reinforcing plate is formed in the periphery of the notched part. Also, there is the positioning hole 5 as the reference hole and an exposed part 6 of the reinforcing plate 2 is formed in the periphery of the positioning hole. That is, in the notched part 3 and the positioning hole 5 as the reference holes, shapes formed in the reinforcing plate 2 can be recognized as the reference from both the front and the back. Then, an opening part 7 is opened and an exposed part 8 of the reinforcing plate 2 is formed in the periphery of the opening part. Also, as shown by the top view in Fig. 2, in this flexible wiring board 1, a metal wiring pattern 1 b is formed on the film base substance 1 a and the solid-state imaging element substrate 10 is placed so as to make electrical connection. A chip component 11 or a connector 12 is placed on the flexible wiring board 1 so as to be connected to the metal wiring pattern 1b. Also, a ground part of the metal wiring pattern 1b is electrically connected to the SUS reinforcing plate 2. Further, a substrate in which a black epoxy resin film (not shown) is applied to a back surface as a light blocking film was used in the solid-state imaging element substrate 10 used at this time. In addition, a metal film such as a tungsten thin film formed on a back surface of the solid-state imaging element substrate 10 may be used as this light blocking film.

By having such a configuration, high strength performance by the reinforcing plate 2 having the same outer shape can be ensured while utilizing a merit of thinness of the flexible substrate 1. Also, the notched part 3 or the positioning hole 5 as the reference hole becomes the reference at the time of placing the solid-state imaging element substrate 10 and can also be used as the common reference at the time of placing the lens cabinet 16 in the opposite side as shown in Fig. 3, so that optical axes of the lens 15 and the solid-state imaging element substrate 10 can be aligned with high accuracy. By forming the exposed part 4 of the reinforcing plate, a deviation of the flexible wiring board 1 or an obstacle (for example, a protrusion in an end face) to reference recognition can be avoided and a shape of a SUS end face with high accuracy can be ensured. Also, the exposed part 8 of the reinforcing plate of the periphery of the opening part 7 similarly suppresses occurrence of a shield etc. with respect to an imaging area of the solid-state imaging element substrate 10 and the imaging area can be ensured with high accuracy. Freedom of electrical wiring design improves by installing the chip component 11 on a surface of the flexible wiring board 1. That is, the chip component 11 can be placed in the vicinity of a solid-state imaging element and electrical characteristics can be optimized. Also, by installing the connector 12 on the flexible substrate 1, a signal from the solid-state imaging element substrate 10 can be fetched to the outside and connection to a portable device can be made freely. When the flexible wiring board 1 is made larger than the reinforcing plate 2 and is used as flexible wiring as it is, a strength shortage in a step part to the reinforcing plate 2 is caused. In this case, another flexible wiring board may be directly connected instead of the connector 12. Also, since the metal wiring pattern 1 b is electrically connected to the SUS reinforcing plate 2, noise suppression or electrostatic shielding can be performed, so that stability of electrical characteristics can be obtained. Further, a light blocking film made of a metal thin film such as tungsten is applied to a back surface of the solid-state imaging element substrate 10, so that noise of an imaging signal by light incidence from the back surface of the solid-state imaging element substrate 10 can be eliminated.

Fig. 3 is an exploded perspective view of the solid-state imaging apparatus of the first embodiment, and is the view in which the solid-state imaging apparatus of Fig. 1 is seen from a back surface.

The flexible wiring board 1 and the reinforcing plate 2 whose outer shape is the same size are laminated and integrated, and the notched part 3 and the positioning hole 5 as the reference holes are formed. Then, the opening part 7 is also opened in the reinforcing plate 2 and a step part 13 thinner than the overall thickness of the reinforcing plate 2 is formed in the periphery of the opening part 7. The translucent member 14 is dropped into this step part 13 and is placed in the reinforcing plate 2. Glass having an infrared cut filter function was used in the translucent member 14. Then, a reference protrusion part 17 is formed in the lens cabinet 16 integrated with the optical lens 15. The illustrated reference protrusion part 17 is means fitted into the positioning hole 5 as the reference hole, and a reference protrusion fitted into the notched part 3 is not shown, but is similarly formed.

By having such a configuration, a positional deviation of the translucent member 14 is eliminated and the translucent member 14 can be glued to the step part 13 so as to close the opening part 7 while suppressing expansion of an adhesive for adhesion to an excessive area. Also, by fitting the reference protrusion part 17 of the lens cabinet 16 into the positioning hole 5 as the reference hole or as the notched part 3 as the reference hole, it can be set at the reference common to the opposite solid-state imaging element substrate 10, so that high-accuracy alignment of an optical axis can be performed.

Fig. 4 is a perspective view of the solid-state imaging apparatus of the first embodiment, and is the view seen from the same side as Fig. 1.

The flexible wiring board 1 and the reinforcing plate 2 whose outer shape is the same size are laminated and integrated, and the notched part 3 as the reference hole and the positioning hole 5 as the reference hole are formed. Further, a molded resin 18 is formed so as to cover the solid-state imaging element substrate 10 and the chip component 11. A molded resin notched part 19 is formed so as to avoid the notched part 3 as the reference hole. Also, a wiring cable 20 made of a flat cable is pulled out of the connector 11.

By adopting such a configuration, component dropping of the solid-state imaging element substrate 10 or the chip component 11 is prevented and adhesion can be performed tightly. Also, by forming the molded resin 18 on a back surface of the solid-state imaging element substrate 10, noise by transmitted light from the back surface of the solid-state imaging element substrate 10 can be suppressed. In order to further suppress the transmitted light from the back surface of the solid-state imaging element substrate 10, a light blocking film may be formed on the back surface of the solid-state imaging element substrate 10 as described above. Intrusion of a shield into the notched part 3 as the reference hole can be eliminated by molding the molded resin 18 so as to ensure the molded resin notched part 19. Also, by being molded so as to avoid the connector 12, the wiring cable 20 can be attached after the lens cabinet 16 is installed. When the wiring cable 20 is previously attached, connection of the wiring cable may be reinforced by being molded to the wiring cable 20 and the connector 12 while avoiding the positioning hole 5 as the reference hole.

Fig. 5 is a perspective view of the solid-state imaging apparatus of the first embodiment, and is the view seen from the same side as Fig. 3.

The lens cabinet 16 is installed from the above of the reinforcing plate 2 and the flexible wiring board 1 in which the molded resin 18 is formed. Since the same reference as placement of the solid-state imaging element substrate 10 is used, high-accuracy alignment of an optical axis can be performed.

### (Second embodiment)

Next, a manufacturing method of a solid-state imaging apparatus of an embodiment of the invention will be described.

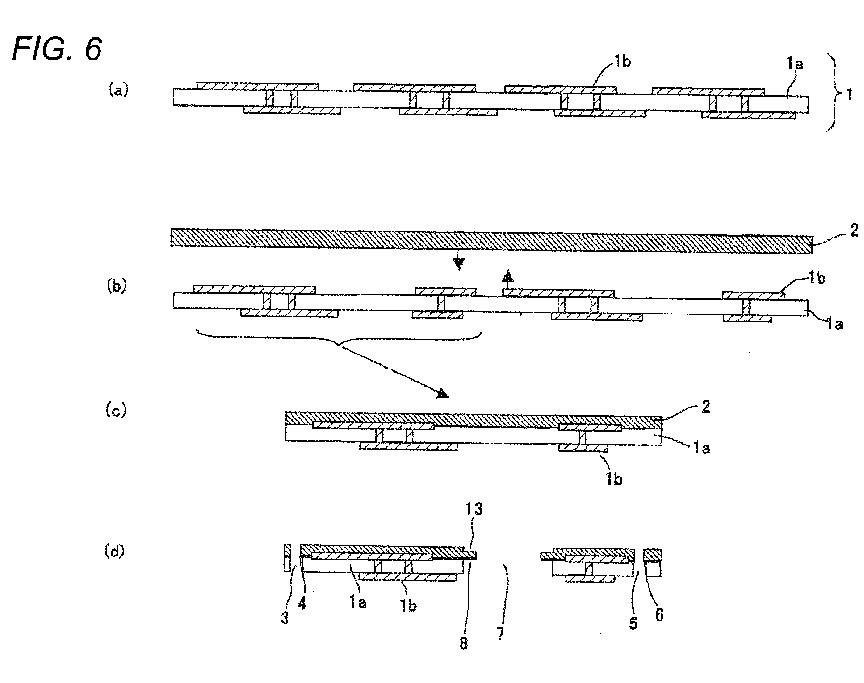

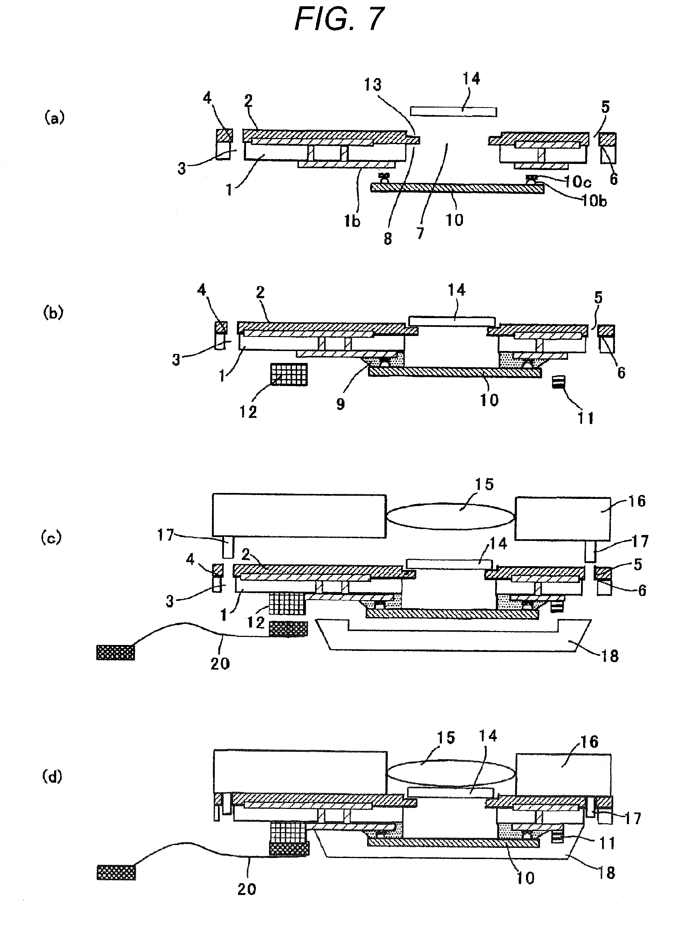

Figs. 6 and 7 are sectional views showing a manufacturing method of a solid-state imaging apparatus of a second embodiment.

In Fig. 6(a), vias are bored in a flexible base material 1 a constructing a flexible wiring board 1, and wiring of wiring patterns 1 b made of metal layers is formed on both surfaces. A polyimide film with a thickness of 25 µm was used in the flexible base material a. In this case, the wiring patterns 1b of multiple cavities were formed at once.

In Fig. 6(b), a reinforcing plate 2 was stuck on the whole surface of the flexible substrate. A SUS plate with a thickness of 150 µm was used in the reinforcing plate. In the case of sticking the flexible wiring board 1 on the reinforcing plate 2, adhesion was performed using a conductive adhesive (not shown). As a result of that, a ground part of wiring of the flexible wiring board 1 is electrically connected to the reinforcing plate 2 using the SUS plate. An insulating film (not shown) is formed on a surface of the wiring pattern which does not want to be grounded in the side of the reinforcing plate 2.

In Fig. 6(c), the outer shape was cut off in individual pieces by press cutting after the flexible wiring board 1 and the reinforcing plate 2 were laminated and integrated.

In Fig. 6(d), an opening part 7 and a notched part 3 or a positioning hole 5 as a reference hole were bored by etching and exposed parts 4, 6 of the reinforcing plate 2 were ensured in the peripheries of the hole parts. Also, a step part 13 for installing a translucent member was formed in the side of the reinforcing plate 2 of the opening part 7. In this manner, a laminated substrate as a mounting substrate for solid-state imaging apparatus of the invention was fabricated.

Using the laminated substrate formed in this manner, as shown in Fig. 7(a), a translucent member 14 was glued to the step part 13 of the reinforcing plate 2 and a solid-state imaging element substrate 10 was placed on the wiring patterns 1 b of the flexible wiring board 1 so as to close the opening part as opposed to the translucent member 14. A bump 10b was formed on an electrode (not shown) of the solid-state imaging element substrate 10 and a conductive adhesive 10c was transferred and formed to the top of the bump. The bump 10b at this time was formed by a gold wire and a silver paste was used in the conductive adhesive 10c. The conductive adhesive 1 c was heated and cured after the solid-state imaging element substrate 10 was placed on the wiring patterns 1 b using the reference hole 5 as the reference.

In Fig. 7(b), in order to reinforce a connection part, a sealing resin 9 was injected into the periphery of the solid-state imaging element substrate 10 and thereafter was heated and cured. Subsequently, a chip component 11 and a connector 12 were separately connected to the wiring patterns 1b by solder.

In Fig. 7(c), molding was performed and each component was covered with a molded resin 18 and reinforcement was performed. Also, a reference protrusion part 17 was formed in a lens cabinet 16 in which an optical lens 15 was installed, and was fitted by being inserted into the positioning hole 5 as the reference hole. Also, a wiring cable 20 was connected to the connector 12.

In this manner, a solid-state imaging apparatus is manufactured as shown in Fig. 7(d).

By adopting such a manufacturing method, a thin solid-state imaging apparatus with high rigidity, high accuracy and high reliability can be manufactured simply.

Also, a mounting strength of a chip component or a solid-state imaging element can be reinforced by being covered with the molded resin 18 from a back surface of a solid-state imaging element substrate in the solid-state imaging apparatus of the invention.

According to this configuration, a flexible substrate and a reinforcing plate have the same outer shape dimension and form a laminated structure, and a notch or a reference hole in the case of installing an optical lens or a translucent member and a solid-state imaging element substrate is formed and a surface of the reinforcing plate is exposed to the side of the flexible wiring board in the periphery of the notch or the reference hole and the solid-state imaging element substrate and the translucent member can be placed using commonly its reference hole from the front and the back. Therefore, it is easy to thin a solid-state imaging apparatus and assembly can be done with good workability, and high rigidity and high accuracy of alignment of an optical axis can be obtained.

Also, the translucent member and the optical lens are attached to the side of the reinforcing plate, and the optical lens and the solid-state imaging element substrate can be aligned using a hole for positioning as a common reference from the front and the back. In addition, this hole may not be a through hole or may be a notch.

Also, in the embodiment described above, good imaging characteristics can be obtained by cutting an infrared region of light incident on the solid-state imaging element substrate when an optical filter is used as the translucent member.

Also, a thickness of the periphery of an opening part of the reinforcing plate in which the translucent member used in the solid-state imaging apparatus of the invention is placed may become thinner than the periphery. As a result of that, a positional deviation of the translucent member is eliminated and expansion of an adhesive for placement can also be suppressed.

In addition, it goes without saying that there is a necessity to align the solid-state imaging element substrate with the optical lens, and it is also important to align the translucent member with the solid-state imaging element substrate. This reason will be described.

Light emitted from the optical lens is designed to expand toward the solid-state imaging element substrate and it is constructed so as to emit the light from an exit pupil position exactly. As a result of this, a size of an optical filter constructed of the translucent member 14 requires a dimension in which an adhesion part is added to an opening of a plate-shaped member. Also, in a filter, a uniform film is formed in a vapor deposition apparatus, so that a work size (plate material before division) is limited and the work size is about 70 mm in angular size. Then, dicing and division is made by a diamond blade etc. in the case of forming products from the work size, so that a cost is determined by, that is, the number of products obtained from the work size. Hence, the cost can be reduced by minimizing a size including an adhesion area. Also, when a large filter is used, a solid-state imaging element overlaps with the filter in a plane. The center of the solid-state imaging element is called an effective imaging area and is a region in which light is actually photoelectrically converted into an electrical signal by a phototransistor (Tr), and there are a peripheral circuit etc. in the outside of this effective area and an electrode for wiring is disposed in its outside. Therefore, when the optical filter overlaps with a wiring part, the optical filter and the wiring part are respectively arranged in a thickness direction (optical axis direction), so that the thickness becomes thick. From the above standpoint, it is desirable to use a small filter in order to achieve thinning and cost reduction and therefore, accuracy of the translucent member is required in order to surely cover an effective range of a light beam as described above.

Also, a light blocking film may be formed on a back surface of the solid-state imaging element substrate used in the solid-state imaging apparatus as described above, with the result that occurrence of noise by transmission of light from the back surface can be avoided in the case of a thin solid-state imaging element substrate.

This light blocking film may be a metal film formed on a back surface of the solid-state imaging element substrate. By this configuration, light from the back surface can be blocked more surely in a thin type.

Also, this light blocking film may be a light blocking resin film formed on a back surface of the solid-state imaging element substrate. By this configuration, formation is easy and light from the back surface can be blocked surely.

In addition, in the embodiment described above, an opening part is formed after a flexible wiring board is pasted on a reinforcing plate, but by being cut by a laser etc. at this time, the edge of the flexible wiring board can be formed roundly and occurrence of wastes can be prevented and contamination of an imaging region can be prevented.

The invention described in the first and second embodiments has the following aspect.

As described above, a solid-state imaging apparatus of the invention comprises a laminated substrate constructed of a flexible wiring board having an opening part and a reinforcing plate laminated and integrated with the flexible wiring board, a translucent member placed in the side of the reinforcing plate of the laminated substrate so as to close an opening part, and a solid-state imaging element substrate placed in the side of the flexible wiring board of the laminated substrate, and is **characterized in that** the reinforcing plate comprises a reference hole for solid-state imaging element substrate placement and the reinforcing plate is also exposed to the side of the flexible wiring board in the peripheral edge of the reference hole and a solid-state imaging element substrate and a translucent member are arranged on both surfaces of the laminated substrate using the reference hole as a common reference.

By the configuration described above, a flexible wiring board and a reinforcing plate have the same outer shape dimension and form a laminated structure, and a reference hole in the case of installing a translucent member (or an optical lens) and a solid-state imaging element substrate is formed and a surface of the reinforcing plate is exposed to the side of the flexible wiring board in the periphery of the reference hole and the solid-state imaging element substrate and the translucent member can be placed using commonly its reference hole from the front and the back, with the result that it is easy to thin a solid-state imaging apparatus and assembly can be done with good workability, and high rigidity and high accuracy of alignment of an optical axis can be obtained. As a result of that, an excellent solid-state imaging apparatus capable of miniaturizing a mobile telephone etc. can be provided. The solid-state imaging element substrate herein refers to a substrate in which a solid-state imaging element is formed on a semiconductor substrate such as a silicon substrate, mainly a substrate divided into individual chips. Also, the reference hole includes the so-called notched part whose part is communicated to the outside as well as the so-called positioning hole whose peripheral edge is surrounded by a wall. Further, an outer shape, a wiring pattern, etc. using the reference hole as a reference may be used in alignment indirectly.

Also, in the solid-state imaging apparatus described above, the invention includes a solid-state imaging apparatus wherein the translucent member and an optical lens are attached to the side of the reinforcing plate and the optical lens and the solid-state imaging element substrate are aligned using a reference hole as a common reference from the front and the back. Furthermore, it is desirable to align the translucent member using this reference hole as the common reference.

An optical filter may be used as the translucent member used in the solid-state imaging apparatus of the invention. As a result of that, good imaging characteristics can be obtained by cutting an infrared region of light incident on a solid-state imaging element.

Also, a metal plate may be used as the reinforcing plate used in the solid-state imaging apparatus of the invention. As a result of that, high rigidity of the solid-state imaging apparatus can be obtained.

Also, the reinforcing plate made of the metal plate may be electrically connected to a ground part of a wiring pattern of the flexible wiring board used in the solid-state imaging apparatus of the invention. As a result of that, stability of electrical characteristics can be obtained.

Also, a thickness of the periphery of an opening part of the reinforcing plate in which the translucent member used in the solid-state imaging apparatus of the invention is placed may become thinner than the periphery. As a result of that, a positional deviation of the translucent member is eliminated and expansion of an adhesive for placement can also be suppressed.

Also, an electrical path for fetching an electrical signal from the flexible wiring board used in the solid-state imaging apparatus of the invention by a connector or a wiring substrate may be ensured. As a result of that, the electrical signal can be fetched in a state of decreasing the flexible wiring board and the reinforcing plate to the necessary minimum.

Also, a chip component may be installed on the flexible wiring board used in the solid-state imaging apparatus of the invention. As a result of that, freedom of electrical wiring design improves and the chip component can be placed in the vicinity of a solid-state imaging element and electrical characteristics can be optimized.

Also, resin molding may be performed from a back surface of a solid-state imaging element used in the solid-state imaging apparatus of the invention. As a result of that, a mounting strength of a chip component or the solid-state imaging element can be reinforced.

Also, a light blocking film may be formed on a back surface of a solid-state imaging element substrate used in the solid-state imaging apparatus of the invention. As a result of that, occurrence of noise by transmission of light from the back surface can be avoided in the case of a thin solid-state imaging element substrate.

Also, the light blocking film may be a metal film formed on a back surface of the solid-state imaging element substrate. By this configuration, light from the back surface can be blocked more surely in a thin type.

Also, the light blocking film may be a light blocking resin film formed on a back surface of the solid-state imaging element substrate. By this configuration, formation is easy and light from the back surface can be blocked surely.

Also, a manufacturing method of a solid-state imaging apparatus of the invention is characterized by comprising the steps of sticking a flexible wiring board on a reinforcing plate and forming a laminated body having a through opening part, cutting an outer shape of the laminated body, partially removing the flexible wiring board and forming a reference hole so as to reach the reinforcing plate, installing a solid-state imaging element substrate so as to close an opening part of the flexible substrate using the reference hole as a reference, and installing a translucent member so as to close an opening part of the reinforcing plate.

According to this configuration, high rigidity can be obtained simply by using a reinforcing plate and also, a solid-state imaging apparatus having high-accuracy alignment of an optical axis can be manufactured by using a reference hole. The reference hole herein refers to a hole for positioning and includes the so-called notched part whose part does not have a wall as well as the so-called hole whose periphery is surrounded by a wall.

Also, in the manufacturing method of the solid-state imaging apparatus described above, the invention further includes a step of being positioned from the outside of the translucent member using the reference hole or the notched part as a reference and installing a lens cabinet in which an optical lens is installed in the reinforcing plate.

Also, in the invention in the manufacturing method of the solid-state imaging apparatus described above, a step of forming the laminated body includes a step of forming a through opening part after a flexible wiring board is stuck on a reinforcing plate.

According to this configuration, it becomes unnecessary to align the flexible wiring board with the reinforcing plate, so that manufacture is facilitated.

Also, in the invention in the manufacturing method of the solid-state imaging apparatus described above, a step of forming the laminated body includes a step of aligning a flexible wiring board comprising an opening part with a reinforcing plate comprising an opening part so that the opening parts coincide with each other and a step of sticking the flexible wiring board on the reinforcing plate.

According to this configuration, the opening part of the flexible wiring board and the opening part of the reinforcing plate are formed independently, so that it is also easy to form the opening parts so that sizes of the opening parts differ.

Also, in the invention in the manufacturing method of the solid-state imaging apparatus described above, a step of performing the alignment includes a step of performing alignment so as to expose the peripheral edge of an opening part of the reinforcing plate from an opening part of the flexible substrate.

Also, in the invention in the manufacturing method of the solid-state imaging apparatus described above, a step of forming a reference hole includes a step of etching a flexible wiring board and a reinforcing plate.

By this configuration, position accuracy of the reference hole (or a notched part) with high accuracy can be improved and a surface of the reinforcing plate can be exposed to the side of the flexible wiring board of the periphery of the reference hole.

Also, in the invention in the manufacturing method of the solid-state imaging apparatus described above, a step of installing a solid-state imaging element substrate includes a step of forming a conductive adhesive layer in a bump of the solid-state imaging element substrate and performing flip chip mounting in a flexible substrate and injecting a sealing resin into the periphery of a bonding part.

For example, a mounting method in which after a bump is formed in a wiring part of a solid-state imaging element substrate, a conductive adhesive is transferred to the bump and flip chip mounting is performed in a flexible substrate and electrical bonding is ensured by thermal curing and a sealing resin is injected into the periphery of a bonding part may be used. According to this configuration, thermal deformation of a solid-state imaging element substrate installation part can also be absorbed by the sealing resin and a manufacturing yield is high and electrical characteristics with high reliability capable of coping with a change in temperature at the time of use can be obtained.

Next, a connection structure of two flexible substrates which are third and fourth embodiments according to the invention will be described in detail with reference to the drawings.

### (Third embodiment)

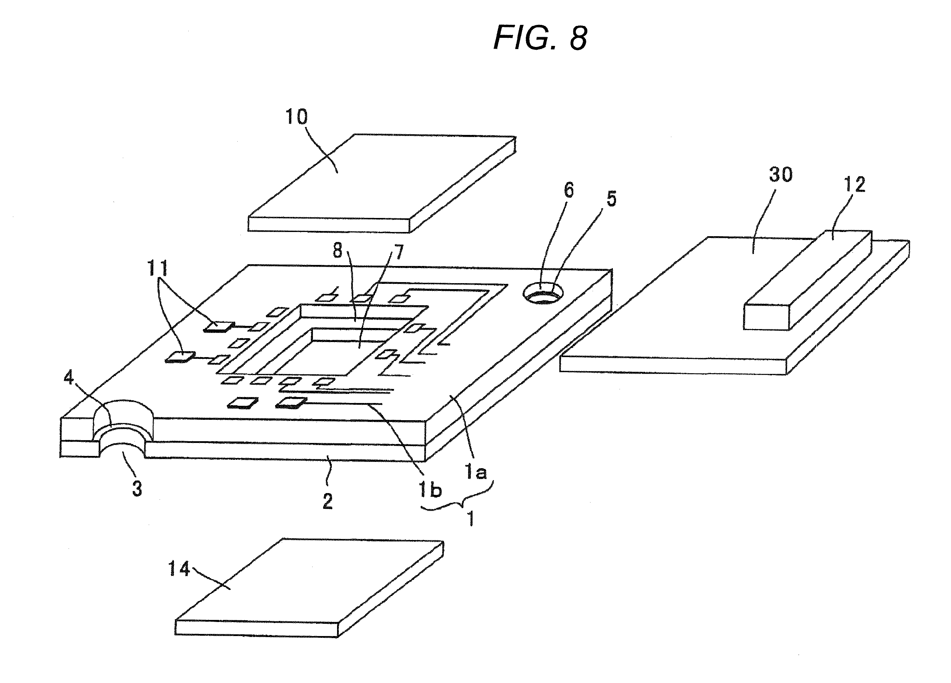

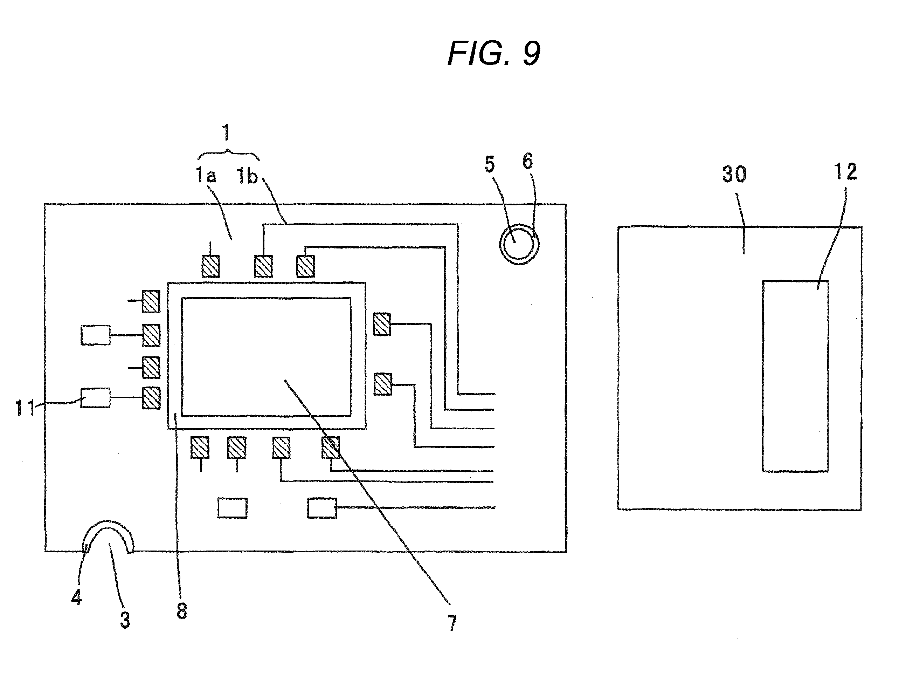

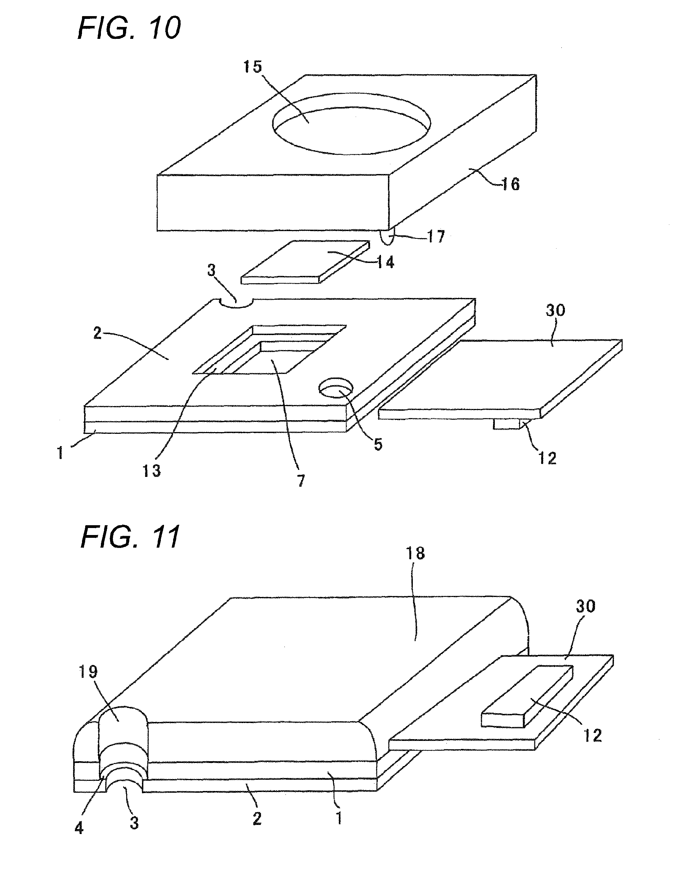

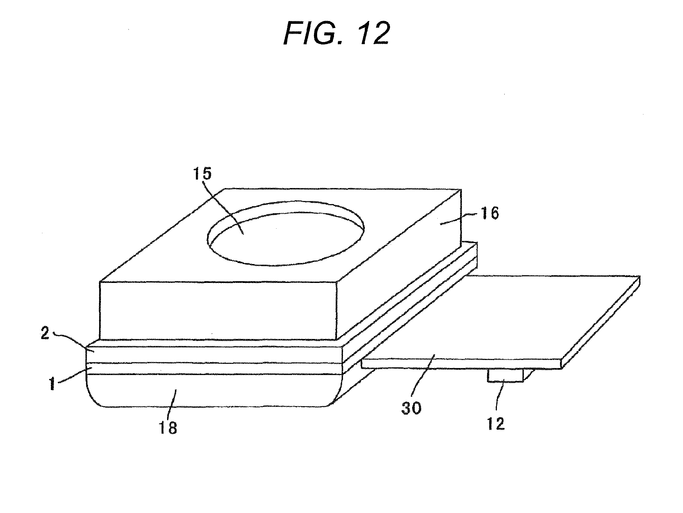

Fig. 8 is an exploded perspective view of a solid-state imaging apparatus of a third embodiment. Fig. 9 is a top view of a flexible wiring board used in the solid-state imaging apparatus of the third embodiment, and Fig. 10 is an exploded perspective view of the solid-state imaging apparatus of the third embodiment, and Fig. 11 is a perspective view of the solid-state imaging apparatus of the third embodiment, and Fig. 12 is a perspective view of the solid-state imaging apparatus of the third embodiment.

As shown in Figs. 8 and 12, a solid-state imaging apparatus of the invention is characterized by comprising a second flexible wiring board 30 bonded to a first flexible wiring board 1, and a resin molded part (a resin package) 18 with which a bonding part between the first flexible wiring board and the second flexible wiring board is covered. That is, this solid-state imaging apparatus comprises a laminated substrate constructed of the first flexible wiring board 1 having an opening part and a reinforcing plate 2 laminated and integrated with this first flexible wiring board 1, an optical lens 15 and a translucent member 14 placed in the side of the reinforcing plate 2 of this laminated substrate so as to close the opening part, and a solid-state imaging element substrate 10 placed in the side of the first flexible wiring board 1 of this laminated substrate, and this reinforcing plate 2 comprises a positioning hole 5 and a notched part 3 as reference holes for placement of the solid-state imaging element substrate, and the reinforcing plate 2 is also exposed to the side of the flexible wiring board 1 in the peripheral edges of this notched part 3 and the positioning hole 5, and the solid-state imaging element substrate, the translucent member 14 and the optical lens 15 (a lens cabinet 16) are arranged on both surfaces of the laminated substrate using these two reference holes as a common reference.

Also in this example, the flexible wiring board 1 having the opening part and the reinforcing plate 2 whose outer shape is the same size are laminated and integrated as shown in Fig. 8. In the flexible wiring board 1 of this case, a polyimide resin film with a thickness of 25 µm was used as a film base substance 1a (base film) and a SUS plate with a thickness of 150 µm was used in the reinforcing plate 2. Then, as shown by the top view in Fig. 9, in this flexible wiring board 1, a metal wiring pattern 1 b is formed on the film base substance 1 a. The metal wiring pattern 1b is formed in the flexible wiring board 1. Further, the solid-state imaging element substrate 10 is placed on the first flexible wiring board 1 so as to make electrical connection. Then, the second flexible wiring board 30 as an extension board was electrically connected to the flexible wiring board 1. In connection of this case, adhesion was performed using a nonconductive adhesive and a method for bringing a wiring pattern of the first flexible wiring board 1 into direct contact with a wiring pattern (not shown) of the second flexible wiring board 30 as the extension board and bringing the flexible wiring boards into conduction was adopted. A chip component 11 and a connector 12 are installed in this extension flexible wiring board 30 and connection to a wiring substrate (not shown) of a portable device body is made by this connector 12. Also, a ground part of the metal wiring pattern 1b is electrically connected to the SUS reinforcing plate 2. Further, a substrate in which a light blocking film (not shown) is applied to a back surface was used in the solid-state imaging element substrate 10 used in this case.

Then, the notched part 3 as the reference hole is formed in the reinforcing plate 2 and an exposed part 4 of the reinforcing plate is formed in the periphery of the notched part. Also, there is the positioning hole 5 as the reference hole and an exposed part 6 of the reinforcing plate 2 is formed in the periphery of the positioning hole. That is, in the notched part 3 and the positioning hole 5 as the reference holes, shapes formed in the reinforcing plate 2 can be recognized as the reference from both the front and the back. Then, an opening part 7 is opened and an exposed part 8 of the reinforcing plate 2 is formed in the periphery of the opening part. The metal wiring pattern 1 b is formed in the flexible wiring board 1 and the solid-state imaging element substrate 10 is placed so as to make electrical connection. The chip component 11 is placed on the first flexible wiring board 1 so as to be connected to the metal wiring pattern 1b. Also, the ground part of the metal wiring pattern 1b is electrically connected to the SUS reinforcing plate 2. Further, a substrate in which a black epoxy resin film (not shown) is applied to a back surface as a light blocking film was used in the solid-state imaging element substrate 10 used at this time. In addition, a metal film such as a tungsten thin film formed on a back surface of the solid-state imaging element substrate 10 may be used as this light blocking film.

By having such a configuration, while utilizing a merit of thinness of the flexible substrate 1, high strength performance by the reinforcing plate 2 having the same outer shape can be ensured and further a close contact strength of a connection part between the mutual flexible wiring boards can be enhanced.

Also, the notched part 3 or the positioning hole 5 as the reference hole becomes the reference at the time of placing the solid-state imaging element substrate 10 and can also be used as the common reference at the time of placing the lens cabinet 16 in the opposite side, so that optical axes of the lens 15 and the solid-state imaging element substrate 10 can be aligned with high accuracy. By forming the exposed parts 4, 6 of the reinforcing plate, a deviation of the first flexible wiring board 1 or an obstacle (for example, a protrusion in an end face) to reference recognition can be avoided and a shape of a SUS end face with high accuracy can be ensured.

Also, the exposed part 8 of the reinforcing plate of the periphery of the opening part 7 similarly suppresses occurrence of a shield etc. with respect to an imaging area of the solid-state imaging element substrate 10 and the imaging area can be ensured with high accuracy. Freedom of electrical wiring design improves by installing the chip component 11 on a surface of the first flexible wiring board 1. That is, the chip component 11 can be placed in the vicinity of a solid-state imaging element and electrical characteristics can be optimized. Also, by installing the connector 12 on the second flexible substrate 30, a signal from the solid-state imaging element substrate 10 can be fetched to the outside through the first flexible substrate 1 and the second flexible substrate 30 directly connected to this first flexible substrate, and connection to a portable device can be made freely. When the first flexible wiring board 1 is made larger than the reinforcing plate 2 and is used as flexible wiring as it is, a break in wiring by bending in a step part to the reinforcing plate 2 may be caused, so that it is preferable to be connected from a separated state thus. Also, since the metal wiring pattern 1b is electrically connected to the SUS reinforcing plate 2, noise suppression or electrostatic shielding can be performed, so that stability of electrical characteristics can be obtained. Further, a light blocking film made of a metal thin film such as tungsten is applied to a back surface of the solid-state imaging element substrate 10, so that noise of an imaging signal by light incidence from the back surface of the solid-state imaging element substrate 10 can be reduced.

By having such a configuration, high strength performance by the reinforcing plate 2 having the same outer shape can be ensured while utilizing a merit of thinness of the first flexible wiring board 1. Also, a connector shape and an extension cable shape with high freedom can be selected while utilizing original flexible characteristics by separately preparing the connector 12 for the second flexible wiring board 30. Also, since connection to the first flexible wiring board 1 can be made after checking whether trouble occurs in the connector 12, a situation in which the solid-state imaging apparatus including the expensive solid-state imaging element substrate 10 becomes NG due to occurrence of a defect in the connector 12 can be avoided, with the result that a cost can be reduced. Also, electrical connection to a portable device body can be made easily using this connector. Also, since the metal wiring pattern 1b is electrically connected to the SUS reinforcing plate 2, noise suppression or electrostatic shielding can be performed, so that stability of electrical characteristics can be obtained. Further, a light blocking film made of a metal thin film such as tungsten is applied to a back surface of the solid-state imaging element substrate 10, so that noise of an imaging signal by light incidence from the back surface of the solid-state imaging element substrate 10 can be eliminated.

Fig. 10 is an exploded perspective view of the solid-state imaging apparatus of the third embodiment, and is the view in which the solid-state imaging apparatus of Fig. 8 is seen from a back surface.

The first flexible wiring board 1 and the reinforcing plate 2 whose outer shape is the same size are laminated and integrated, and the notched part 3 and the positioning hole 5 as the reference holes are formed. Then, the opening part 7 is also opened in the reinforcing plate 2 and a step part 13 thinner than the overall thickness of the reinforcing plate 2 is formed in the periphery of the opening part 7. The translucent member 14 is dropped into this step part 13 and is placed in the reinforcing plate 2. Glass having an infrared cut filter function was used in the translucent member 14. Then, a reference protrusion part 17 is formed in the lens cabinet 16 integrated with the optical lens 15. The illustrated reference protrusion part 17 is means fitted into the positioning hole 5 as the reference hole, and a reference protrusion fitted into the notched part 3 is not shown, but is similarly formed. Numeral 30 is the second flexible wiring board.

By having such a configuration, a positional deviation of the translucent member 14 is eliminated and the translucent member 14 can be glued to the step part 13 so as to close the opening part 7 while suppressing expansion of an adhesive for adhesion to an excessive area. Also, by fitting the reference protrusion part 17 of the lens cabinet 16 into the positioning hole 5 as the reference hole or as the notched part 3 as the reference hole, it can be set at the reference common to the opposite solid-state imaging element substrate 10, so that high-accuracy alignment of an optical axis can be performed.

Fig. 11 is a perspective view of the solid-state imaging apparatus of the third embodiment, and is the view seen from the same side as Fig. 8.

The flexible wiring board 1 and the reinforcing plate 2 whose outer shape is the same size are laminated and integrated, and the notched part 3 as the reference hole and the positioning hole 5 as the reference hole are formed. Then, a molded resin 18 is formed so as to cover a bonding part between the flexible wiring board 1 and the flexible wiring board 30. In this case, the solid-state imaging element substrate 10 and the chip component 11 are also covered with the molded resin 18. Then, a molded resin notched part 19 is formed so as to avoid the notched part 3 as the reference hole. Also, it is not shown, but the molded resin 18 does not protrude from the reference hole 5 and there is no obstacle to fitting of the reference protrusion part 17 of the lens cabinet 16.

By adopting such a configuration, component dropping of the solid-state imaging element substrate 10 or the chip component 11 is prevented and adhesion can be performed tightly. Further, by forming the molded resin 18 on a back surface of the solid-state imaging element substrate 10, noise by transmitted light from the back surface of the solid-state imaging element substrate 10 can be suppressed. In order to further suppress the transmitted light from the back surface of the solid-state imaging element substrate 10, a light blocking film may be formed on the back surface of the solid-state imaging element substrate 10 as described above. Intrusion of a shield into the notched part 3 as the reference hole can be eliminated by molding the molded resin 18 so as to ensure the molded resin notched part 19.

Fig. 12 is a perspective view of the solid-state imaging apparatus of the third embodiment, and is the view seen from the same side as Fig. 10.

The lens cabinet 16 is installed from the above of the reinforcing plate 2 and the flexible wiring board 1 in which the molded resin 18 is formed. Since the same reference as placement of the solid-state imaging element substrate 10 is used, high-accuracy alignment of an optical axis can be performed.

### (Fourth embodiment)

Next, a manufacturing method of a solid-state imaging apparatus of an embodiment of the invention will be described.

Since steps to formation of a laminated substrate are similar to the steps of Figs. 6(a) to 6(d) described in the second embodiment, the description is herein omitted.

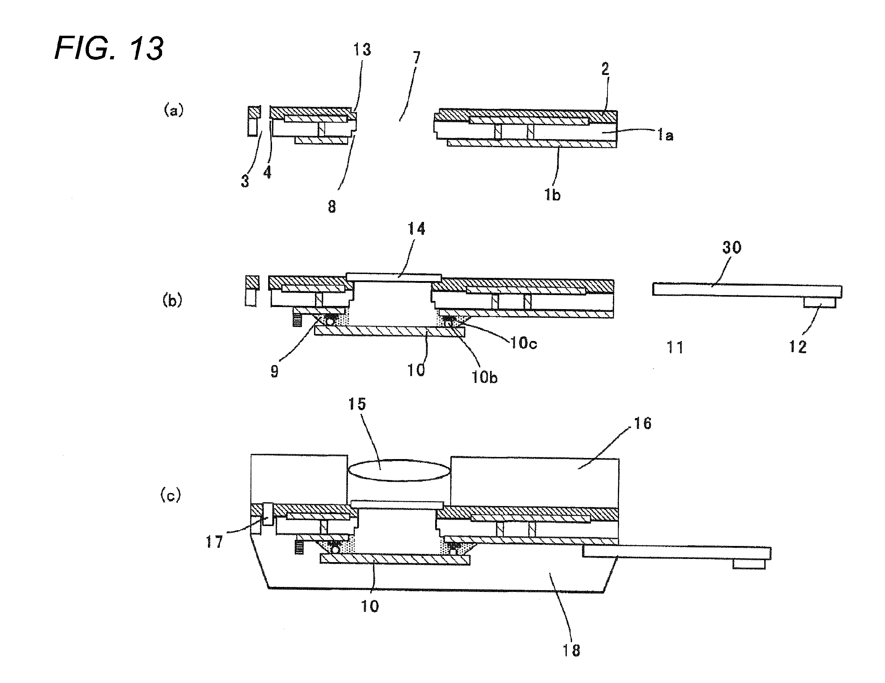

Fig. 13 is a sectional view showing a manufacturing method of a solid-state imaging apparatus of a fourth embodiment. Steps after a laminated substrate is formed will herein be described.

In a manner similar to the second embodiment, vias are bored in a flexible base material 1 a constructing a flexible wiring board 1, and wiring of wiring patterns 1 b made of metal layers is formed on both surfaces, and a reinforcing plate 2 is stuck on the whole surface, and after lamination and integration, the outer shape is cut off in individual pieces by press cutting, and an opening part 7 and a notched part 3 or a positioning hole 5 as a reference hole are bored by etching and also, exposed parts 4, 6 of the reinforcing plate are ensured in the peripheries of the hole parts and further, a step part 13 for installing a translucent member is formed in the side of the reinforcing plate 2 of the opening part 7, and a laminated substrate as a mounting substrate for solid-state imaging apparatus is fabricated.

Using the laminated substrate (Fig. 13(a)) formed in this manner, as shown in Fig. 13(b), a translucent member 14 was glued to the step part 13 of the reinforcing plate 2 and a solid-state imaging element substrate 10 was placed on the wiring patterns 1b of the flexible wiring board 1 so as to close the opening part as opposed to the translucent member 14. At this time, a bump 10b was formed on an electrode (not shown) of the solid-state imaging element substrate 10 and a conductive adhesive 10c was transferred and formed to the top of the bump. The bump 10b at this time was formed by a gold wire and a silver paste was used in the conductive adhesive 10c. The conductive adhesive 1 c was heated and cured after the solid-state imaging element substrate 10 was placed on the wiring patterns 1 b using the reference hole 5 as the reference. Subsequently, in order to reinforce a connection part, a sealing resin 9 was injected and was heated and cured.

Then, as shown in Fig. 13(c), a second flexible wiring board 30 as an extension board was bonded to the first flexible wiring board 1. In bonding at this time, a nonconductive adhesive (not shown) was used and a method for bringing the wiring pattern 1b of the first flexible wiring board 1 into direct contact with a wiring pattern of the second flexible wiring board 30 as the extension board and bringing the flexible wiring boards into conduction was adopted. Then, a molded resin 18 is formed so as to cover a bonding part between the first flexible wiring board 1 and the second flexible wiring board 30. At this time, the solid-state imaging element substrate 10 and a chip component 11 are also covered. Then, a solid-state imaging apparatus is completed by placing a lens cabinet 16 in which an optical lens 15 is installed.

By adopting such a manufacturing method, a thin solid-state imaging apparatus with high rigidity, high accuracy, high reliability and further high freedom in an extension cable can be manufactured simply since a close contact strength of a connection part between the mutual flexible wiring boards can be enhanced.

Also, a mounting strength of a chip component or a solid-state imaging element can be reinforced by being covered with the molded resin 18 from a back surface of a solid-state imaging element substrate in the solid-state imaging apparatus of the invention.

Also, a flexible substrate and a reinforcing plate have the same outer shape dimension and form a laminated structure, and a notch or a reference hole in the case of installing an optical lens or a translucent member and a solid-state imaging element substrate is formed and a surface of the reinforcing plate is exposed to the side of the flexible wiring board in the periphery of the notch or the reference hole and the solid-state imaging element substrate and the translucent member can be placed using commonly its reference hole from the front and the back. Therefore, it is easy to thin a solid-state imaging apparatus and assembly can be done with good workability, and high rigidity and high accuracy of alignment of an optical axis can be obtained.

In addition, this hole may not be a through hole or may be a notch.

Also, in the embodiment described above, good imaging characteristics can be obtained by cutting an infrared region of light incident on the solid-state imaging element substrate when an optical filter is used as the translucent member.

Also, a thickness of the periphery of an opening part of the reinforcing plate in which the translucent member used in the solid-state imaging apparatus of the invention is placed may become thinner than the periphery. As a result of that, a positional deviation of the translucent member is eliminated and expansion of an adhesive for placement can also be suppressed.

In addition, it goes without saying that there is a necessity to align the solid-state imaging element substrate with the optical lens, and it is also important to align the translucent member with the solid-state imaging element substrate. This reason will be described.

Light emitted from the optical lens is designed to expand toward the solid-state imaging element substrate and it is constructed so as to emit the light from an exit pupil position exactly. As a result of this, a size of an optical filter constructed of the translucent member 14 requires a dimension in which an adhesion part is added to an opening of a plate-shaped member. Also, in a filter, a uniform film is formed in a vapor deposition apparatus, so that a work size (plate material before division) is limited and the work size is about 70 mm in angular size. Then, dicing and division is made by a diamond blade etc. in the case of forming products from the work size, so that a cost is determined by, that is, the number of products obtained from the work size. Hence, the cost can be reduced by minimizing a size including an adhesion area. Also, when a large filter is used, a solid-state imaging element overlaps with the filter in a plane. The center of the solid-state imaging element is called an effective imaging area and is a region in which light is actually photoelectrically converted into an electrical signal by a phototransistor (Tr), and there are a peripheral circuit etc. in the outside of this effective area and an electrode for wiring is disposed in its outside. Therefore, when the optical filter overlaps with a wiring part, the optical filter and the wiring part are respectively arranged in a thickness direction (optical axis direction), so that the thickness becomes thick. From the above standpoint, it is desirable to use a small filter in order to achieve thinning and cost reduction and therefore, accuracy of the translucent member is required in order to surely cover an effective range of a light beam as described above.

Also, a light blocking film may be formed on a back surface of the solid-state imaging element substrate used in the solid-state imaging apparatus as described above, with the result that occurrence of noise by transmission of light from the back surface can be avoided in the case of a thin solid-state imaging element substrate.

This light blocking film may be a metal film formed on a back surface of the solid-state imaging element substrate. By this configuration, light from the back surface can be blocked more surely in a thin type.

Also, this light blocking film may be a light blocking resin film formed on a back surface of the solid-state imaging element substrate. By this configuration, formation is easy and light from the back surface can be blocked surely.

In addition, in the embodiment described above, an opening part is formed after a first flexible wiring board is pasted on a reinforcing plate, but by being cut by a laser etc. at this time, the edge of the flexible wiring board can be formed roundly and occurrence of wastes can be prevented and contamination of an imaging region can be prevented.

The invention described in the third and fourth embodiments has the following aspect.

As described above, a solid-state imaging apparatus of the invention is characterized by comprising a first flexible wiring board having an opening part, a reinforcing plate having an opening part coinciding with the opening part and laminated to the first flexible wiring board, a translucent member attached to the side of the reinforcing plate so as to close the opening part, a solid-state imaging element substrate attached to the side of the flexible wiring board, a second flexible wiring board bonded to the first flexible wiring board, and a resin molded part with which a bonding part between the first flexible wiring board and the second flexible wiring board is covered.

By this configuration, the solid-state imaging apparatus has high rigidity in spite of the thin and miniature apparatus, and an adhesive strength of a connection part between the mutual flexible wiring boards can be enhanced. Also, this configuration has an effect capable of having high freedom in a shape of wiring extension.

Also, in the solid-state imaging apparatus described above, the invention includes a solid-state imaging apparatus wherein a component is installed on the first flexible wiring board and the resin molded part is formed so as to cover the component.

By this configuration, adhesion properties of the component can be enhanced more and reliability can be improved. In addition, the component herein includes a chip component, a solid-state imaging element substrate, etc.

Also, in the solid-state imaging apparatus described above, the invention includes a solid-state imaging apparatus wherein in the side of the reinforcing plate, the translucent member and an optical lens are oppositely placed in a state of sandwiching the opening part.

Also, in the solid-state imaging apparatus described above, the invention includes a solid-state imaging apparatus wherein the translucent member and an optical lens are attached to the side of the reinforcing plate and the optical lens and the solid-state imaging element substrate are aligned using a reference hole formed in the laminated substrate as a common reference from the front and the back.

By this configuration, a first flexible wiring board and a reinforcing plate have the same outer shape dimension and form a laminated structure, and a reference hole in the case of installing a translucent member (or an optical lens) and a solid-state imaging element substrate is formed and a surface of the reinforcing plate is exposed to the side of the flexible wiring board in the periphery of the reference hole and the solid-state imaging element substrate and the translucent member can be placed using commonly its reference hole from the front and the back. As a result, it is easy to thin a solid-state imaging apparatus and assembly can be done with good workability, and high rigidity and high accuracy of alignment of an optical axis can be obtained. As a result of that, a solid-state imaging apparatus capable of miniaturizing a mobile telephone etc. can be provided. The solid-state imaging element substrate herein refers to a substrate in which a solid-state imaging element substrate is formed on a semiconductor substrate such as a silicon substrate, mainly a substrate divided into individual chips. Also, the reference hole includes the so-called notched part whose part is communicated to the outside as well as the so-called positioning hole whose peripheral edge is surrounded by a wall. Further, an outer shape, a wiring pattern, etc. using the reference hole as a reference may be used in alignment indirectly.

Also, in the solid-state imaging apparatus described above, the invention includes a solid-state imaging apparatus wherein the translucent member and an optical lens are attached to the side of the reinforcing plate and the optical lens and the solid-state imaging element substrate are aligned using a reference hole as a common reference from the front and the back. Furthermore, it is desirable to align the translucent member using this reference hole as the common reference.

An optical filter may be used as the translucent member used in the solid-state imaging apparatus of the invention. As a result of that, good imaging characteristics can be obtained by cutting an infrared region of light incident on a solid-state imaging element.

Also, a metal plate may be used as the reinforcing plate used in the solid-state imaging apparatus of the invention. As a result of that, high rigidity of the solid-state imaging apparatus can be obtained.

Also, the metal reinforcing plate may be electrically connected to a ground part of a wiring pattern of the flexible wiring board used in the solid-state imaging apparatus of the invention. As a result of that, stability of electrical characteristics can be obtained.

Also, a light blocking film may be formed on a back surface of a solid-state imaging element substrate used in the solid-state imaging apparatus of the invention. As a result of that, occurrence of noise by transmission of light from the back surface can be avoided in the case of a thin solid-state imaging element substrate.

Also, in the solid-state imaging apparatus described above, the invention includes a solid-state imaging apparatus wherein a thickness of the periphery of an opening part of the reinforcing plate in which the translucent member is placed becomes thinner than the periphery.

Also, in the solid-state imaging apparatus described above, the invention includes a solid-state imaging apparatus wherein a connector is disposed on the second flexible wiring board.

Also, in the solid-state imaging apparatus described above, the invention includes a solid-state imaging apparatus wherein resin molding is performed in the solid-state imaging element substrate and other installed component.

Also, in the solid-state imaging apparatus described above, the invention includes a solid-state imaging apparatus wherein a light blocking film is formed on a back surface of the solid-state imaging element substrate.

Also, the light blocking film may be a metal film formed on a back surface of the solid-state imaging element substrate. By this configuration, light from the back surface can be blocked more surely in a thin type.

Also, the light blocking film may be a light blocking resin film formed on a back surface of the solid-state imaging element substrate. By this configuration, formation is easy and light from the back surface can be blocked surely.

Also, a manufacturing method of a solid-state imaging apparatus of the invention is characterized by comprising the steps of sticking a first flexible wiring board on a reinforcing plate, cutting an outer shape by press, installing a solid-state imaging element substrate so as to close an opening part of the first flexible substrate, installing a translucent member so as to close an opening part of the reinforcing plate, bonding a second flexible wiring board to the first flexible wiring board, and performing resin molding so as to cover a bonding part between the first flexible wiring board and the second flexible wiring board and the solid-state imaging element substrate. As a result, a thin and miniature solid-state imaging apparatus having high rigidity and high freedom in a shape of wiring extension can be manufactured simply.

Also, as a method for installing a solid-state imaging element substrate in the manufacturing method of the solid-state imaging apparatus of the invention, a mounting method in which after a bump is formed in a wiring part of a solid-state imaging element substrate, a conductive adhesive is transferred to the bump and flip chip mounting is performed in a flexible substrate and electrical bonding is ensured by thermal curing and a sealing resin is injected into the periphery of a bonding part may be used. As a result of that, electrical characteristics with high reliability capable of coping with thermal deformation in a solid-state imaging element substrate installation part can be obtained.

By using the solid-state imaging apparatus of the invention and the manufacturing method thereof thus, the solid-state imaging apparatus can be thinned and miniaturized and the solid-state imaging apparatus having high rigidity can be manufactured simply. As a result of that, a portable terminal apparatus can also be thinned and miniaturized.

According to the invention, a reinforcing plate and a first flexible wiring board having opening parts are laminated and integrated with the outer shapes equalized and also a translucent member and a solid-state imaging element substrate are oppositely placed so as to close the opening parts and a second flexible wiring board is bonded to the first flexible wiring board and resin molding is performed so as to cover a bonding part between the first flexible wiring board and the second flexible wiring board, so that the solid-state imaging apparatus can be thinned and miniaturized and a close contact strength of a connection part between the mutual flexible substrates can be enhanced and the solid-state imaging apparatus having high rigidity and the manufacturing method thereof can be provided simply.

A structure in which a first flexible wiring board which is fifth and sixth embodiments according to the invention is connected to a second flexible wiring board on which a chip component is installed will hereinafter be described in detail with reference to the drawings.

### (Fifth embodiment)

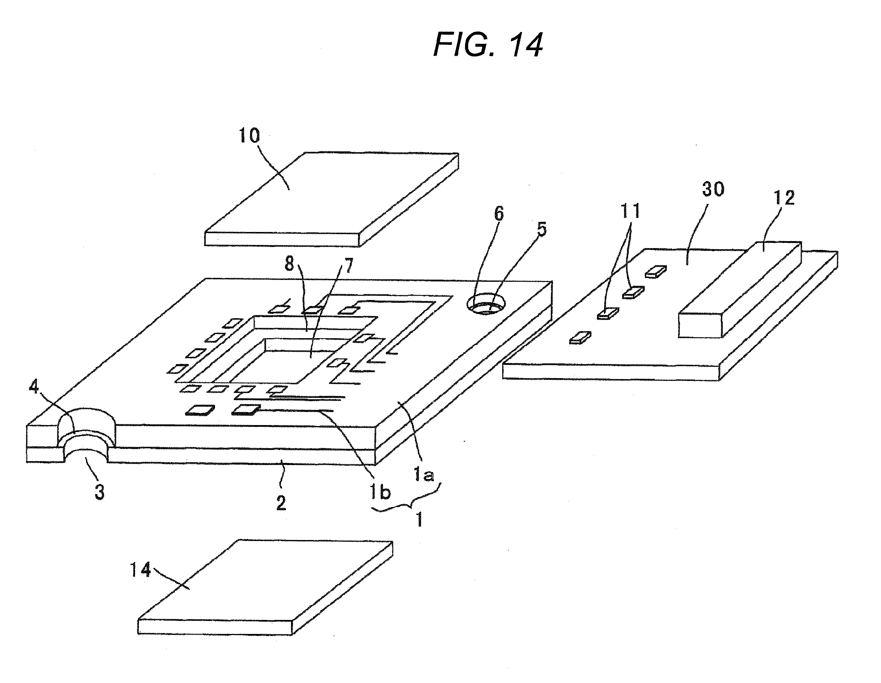

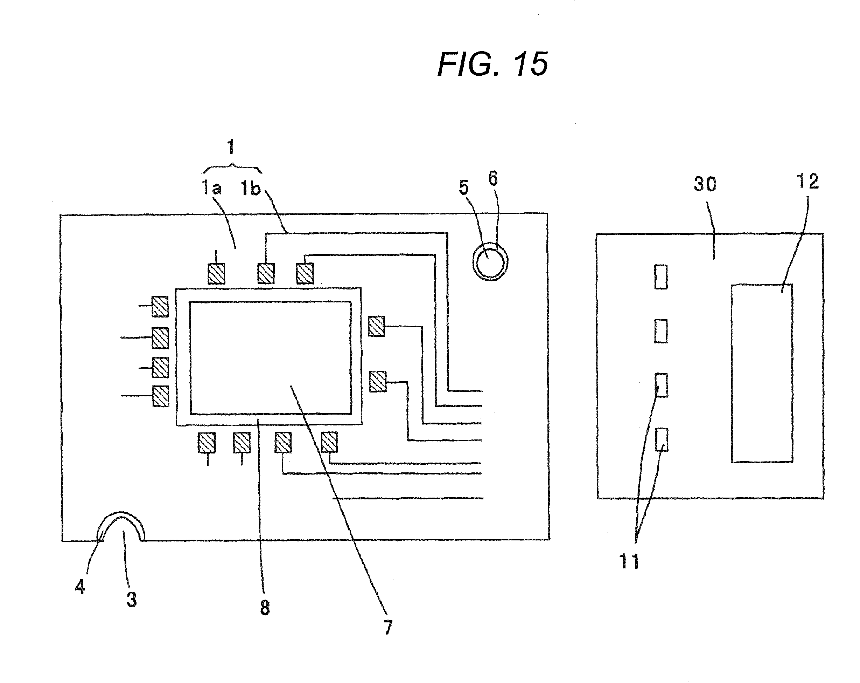

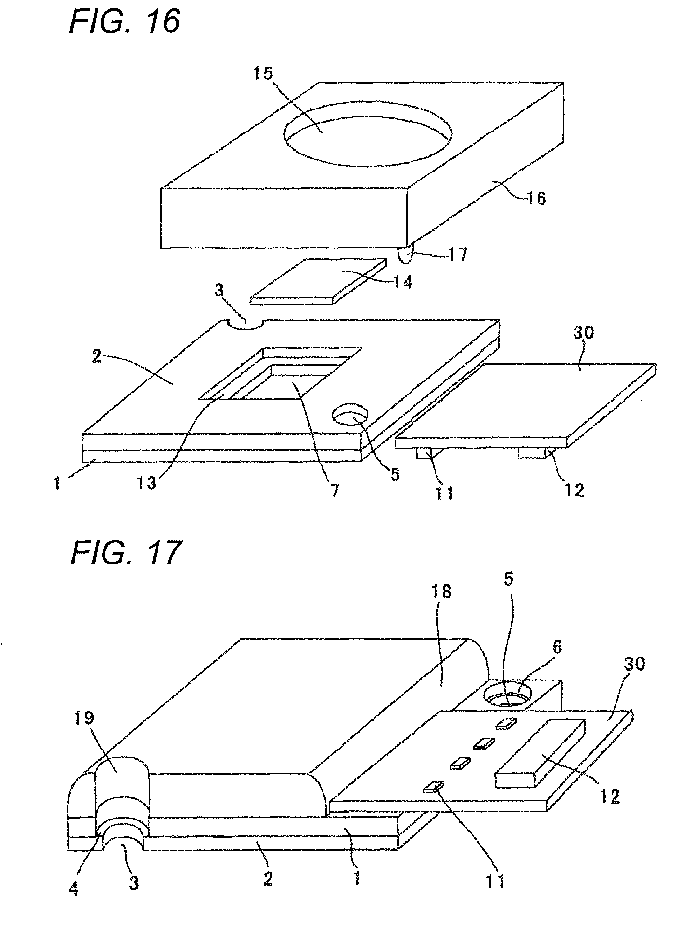

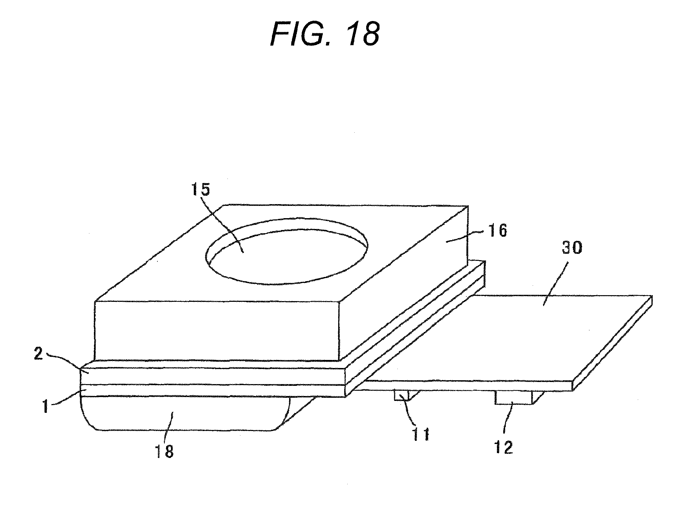

Fig. 14 is an exploded perspective view of a solid-state imaging apparatus of a fifth embodiment. Fig. 15 is a top view of a flexible wiring board used in the solid-state imaging apparatus of the fifth embodiment, and Fig. 16 is an exploded perspective view of the solid-state imaging apparatus of the fifth embodiment, and Fig. 17 is a perspective view of the solid-state imaging apparatus of the fifth embodiment, and Fig. 18 is a perspective view of the solid-state imaging apparatus of the fifth embodiment.

As shown in Fig. 14, a solid-state imaging apparatus of the invention comprises a second flexible wiring board 30 bonded to a first flexible wiring board 1, and is **characterized in that** chip components 11 and a connector 12 are installed on this second flexible wiring board 30. That is, this solid-state imaging apparatus comprises a laminated substrate constructed of the first flexible wiring board 1 having an opening part and a reinforcing plate 2 laminated and integrated with this first flexible wiring board 1, an optical lens 15 and a translucent member 14 placed in the side of the reinforcing plate 2 of this laminated substrate so as to close the opening part, and a solid-state imaging element substrate 10 placed in the side of the first flexible wiring board 1 of this laminated substrate, and this reinforcing plate 2 comprises a positioning hole 5 and a notched part 3 as reference holes for placement of the solid-state imaging element substrate, and the reinforcing plate 2 is also exposed to the side of the flexible wiring board 1 in the peripheral edges of this notched part 3 and the positioning hole 5, and the solid-state imaging element substrate, the translucent member 14 and the optical lens 15 (a lens cabinet 16) are arranged on both surfaces of the laminated substrate using these two reference holes as a common reference.

Also in this example, the flexible wiring board 1 having the opening part and the reinforcing plate 2 whose outer shape is the same size are laminated and integrated as shown in Fig. 14. In the flexible wiring board 1 of this case, a polyimide resin film with a thickness of 25 µm was used as a film base substance 1 a (base film) and a SUS plate with a thickness of 150 µm was used in the reinforcing plate 2. Then, as shown by the top view in Fig. 15, in this flexible wiring board 1, a metal wiring pattern 1 b is formed on the film base substance 1 a. Further, the solid-state imaging element substrate 10 is placed on the first flexible wiring board 1 so as to make electrical connection. Then, the second flexible wiring board 30 as an extension board was electrically connected to the flexible wiring board 1. In connection of this case, adhesion was performed using a nonconductive adhesive and a method for bringing a wiring pattern of the first flexible wiring board 1 into direct contact with a wiring pattern (not shown) of the second flexible wiring board 30 as the extension board and bringing the flexible wiring boards into conduction was adopted. The chip components 11 and the connector 12 are installed in this extension flexible wiring board 30 and connection to a wiring substrate (not shown) of a portable device body is made by this connector 12.

Then, the notched part 3 as the reference hole is formed in the reinforcing plate 2 and an exposed part 4 of the reinforcing plate is formed in the periphery of the notched part. Also, there is the positioning hole 5 as the reference hole and an exposed part 6 of the reinforcing plate 2 is formed in the periphery of the positioning hole. That is, in the notched part 3 and the positioning hole 5 as the reference holes, shapes formed in the reinforcing plate 2 can be recognized as the reference from both the front and the back. Then, an opening part 7 is opened and an exposed part 8 of the reinforcing plate 2 is formed in the periphery of the opening part. The metal wiring pattern 1b is formed in the flexible wiring board 1 and the solid-state imaging element substrate 10 is placed so as to make electrical connection. Also, the ground part of the metal wiring pattern 1b is electrically connected to the SUS reinforcing plate 2. Further, a substrate in which a black epoxy resin film (not shown) is applied to a back surface as a light blocking film was used in the solid-state imaging element substrate 10 used at this time. In addition, a metal film such as a tungsten thin film formed on a back surface of the solid-state imaging element substrate 10 may be used as this light blocking film.

By having such a configuration, while utilizing a merit of thinness of the flexible substrate 1, high strength performance by the reinforcing plate 2 having the same outer shape can be ensured.

Also, the notched part 3 or the positioning hole 5 as the reference hole becomes the reference at the time of placing the solid-state imaging element substrate 10 and can also be used as the common reference at the time of placing the lens cabinet 16 in the opposite side, so that optical axes of the lens 15 and the solid-state imaging element substrate 10 can be aligned with high accuracy. By forming the exposed parts 4, 6 of the reinforcing plate, a deviation of the first flexible wiring board 1 or an obstacle (for example, a protrusion in an end face) to reference recognition can be avoided and a shape of a SUS end face with high accuracy can be ensured.

The exposed part 8 of the reinforcing plate of the periphery of the opening part 7 suppresses occurrence of a shield etc. with respect to an imaging area of the solid-state imaging element substrate 10 and the imaging area can be ensured with high accuracy. Also, by installing the connector 12 on the second flexible substrate 30, a signal from the solid-state imaging element substrate 10 can be fetched to the outside through the first flexible substrate 1 and the second flexible substrate 30 directly connected to this first flexible substrate, and connection to a portable device can be made freely. When the first flexible wiring board 1 is made larger than the reinforcing plate 2 and is used as flexible wiring as it is, a break in wiring by bending in a step part to the reinforcing plate 2 may be caused, so that it is preferable to be connected from a separated state thus. Also, since the metal wiring pattern 1b is electrically connected to the SUS reinforcing plate 2, noise suppression or electrostatic shielding can be performed, so that stability of electrical characteristics can be obtained. Further, a light blocking film made of a metal thin film such as tungsten is applied to a back surface of the solid-state imaging element substrate 10, so that noise of an imaging signal by light incidence from the back surface of the solid-state imaging element substrate 10 can be reduced.

By having such a configuration, high strength performance by the reinforcing plate 2 having the same outer shape can be ensured while utilizing a merit of thinness of the first flexible wiring board 1. Also, a connector shape and an extension cable shape with high freedom can be selected while utilizing original flexible characteristics by separately preparing the chip components 11 and the connector 12 for the second flexible wiring board 30. Also, since connection to the first flexible wiring board 1 can be made after checking whether trouble occurs in the chip component 11 or the connector 12, a situation in which the solid-state imaging apparatus including the expensive solid-state imaging element substrate 10 becomes NG due to occurrence of a defect in the chip component 11 can be avoided, with the result that a cost can be reduced.

Fig. 16 is an exploded perspective view of the solid-state imaging apparatus of the fifth embodiment, and is the view in which the solid-state imaging apparatus of Fig. 14 is seen from a back surface.

The first flexible wiring board 1 and the reinforcing plate 2 whose outer shape is the same size are laminated and integrated, and the notched part 3 and the positioning hole 5 as the reference holes are formed. Then, the opening part 7 is also opened in the reinforcing plate 2 and a step part 13 thinner than the overall thickness of the reinforcing plate 2 is formed in the periphery of the opening part 7. The translucent member 14 is dropped into this step part 13 and is placed in the reinforcing plate 2. Glass having an infrared cut filter function was used in the translucent member 14. Then, a reference protrusion part 17 is formed in the lens cabinet 16 integrated with the optical lens 15. The illustrated reference protrusion part 17 is means fitted into the positioning hole 5 as the reference hole, and a reference protrusion fitted into the notched part 3 is not shown, but is similarly formed. Numeral 30 is the second flexible wiring board.

By having such a configuration, a positional deviation of the translucent member 14 is eliminated and the translucent member 14 can be glued to the step part 13 so as to close the opening part 7 while suppressing expansion of an adhesive for adhesion to an excessive area. Also, by fitting the reference protrusion part 17 of the lens cabinet 16 into the positioning hole 5 as the reference hole or as the notched part 3 as the reference hole, it can be set at the reference common to the opposite solid-state imaging element substrate 10, so that high-accuracy alignment of an optical axis can be performed.

Fig. 17 is a perspective view of the solid-state imaging apparatus of the fifth embodiment, and is the view seen from the same side as Fig. 14.

The flexible wiring board 1 and the reinforcing plate 2 whose outer shape is the same size are laminated and integrated, and the notched part 3 as the reference hole and the positioning hole 5 as the reference hole are formed. Further, a molded resin 18 is formed so as to cover the solid-state imaging element substrate 10 and the chip component. A molded resin notched part 19 is formed so as to avoid the notched part 3 as the reference hole.

By adopting such a configuration, the solid-state imaging element substrate 10 can be glued tightly. Also, by forming the molded resin 18 on a back surface of the solid-state imaging element substrate 10, noise by transmitted light from the back surface of the solid-state imaging element substrate 10 can be suppressed. In order to further suppress the transmitted light from the back surface of the solid-state imaging element substrate 10, a light blocking film may be formed on the back surface of the solid-state imaging element substrate 10 as described above. Intrusion of a shield into the notched part 3 as the reference hole can be eliminated by molding the molded resin 18 so as to ensure the molded resin notched part 19.

Fig. 18 is a perspective view of the solid-state imaging apparatus of the fifth embodiment, and is the view seen from the same side as Fig. 16.

The lens cabinet 16 is installed from the above of the reinforcing plate 2 and the flexible wiring board 1 in which the molded resin 18 is formed. Since the same reference as placement of the solid-state imaging element substrate 10 is used, high-accuracy alignment of an optical axis can be performed.

### (Sixth embodiment)

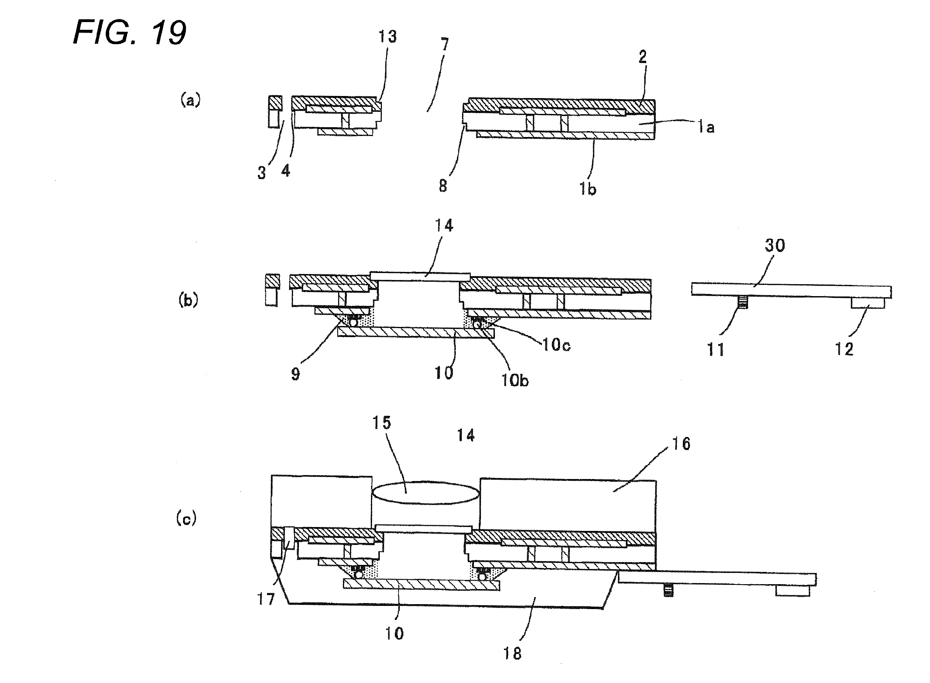

Fig. 19 is a sectional view showing a manufacturing method of a solid-state imaging apparatus of a sixth embodiment.

Since steps to formation of a laminated substrate are similar to the steps of Figs. 6(a) to 6(d) described in the second embodiment, the description is herein omitted and steps after the laminated substrate is formed will herein be described.

In a manner similar to the second and fourth embodiments, vias are bored in a flexible base material 1 a constructing a flexible wiring board 1, and wiring of wiring patterns 1 b made of metal layers is formed on both surfaces, and a reinforcing plate 2 is stuck on the whole surface, and after lamination and integration, the outer shape is cut off in individual pieces by press cutting, and an opening part 7 and a notched part 3 or a positioning hole 5 as a reference hole are bored by etching and also, exposed parts 4, 6 of the reinforcing plate are ensured in the peripheries of the hole parts and further, a step part 13 for installing a translucent member is formed in the side of the reinforcing plate 2 of the opening part 7, and a laminated substrate as a mounting substrate for solid-state imaging apparatus is fabricated.

Using the laminated substrate (Fig. 19(a)) formed in this manner, as shown in Fig. 19(b), a translucent member 14 was glued to the step part 13 of the reinforcing plate 2 and a solid-state imaging element substrate 10 was placed on the wiring patterns 1b of the flexible wiring board 1 so as to close the opening part as opposed to the translucent member 14. At this time, a bump 10b was formed on an electrode (not shown) of the solid-state imaging element substrate 10 and a conductive adhesive 10c was transferred and formed to the top of the bump. The bump 10b at this time was formed by a gold wire and a silver paste was used in the conductive adhesive 10c. The conductive adhesive 1 c was heated and cured after the solid-state imaging element substrate 10 was placed on the wiring patterns 1 b using the reference hole 3 as the reference. Subsequently, in order to reinforce a connection part, a sealing resin 9 was injected and was heated and cured. Also, a second flexible wiring board 30 was separately prepared as an extension board, and a chip component 11 and a connector 12 were connected by solder.

Then, as shown in Fig. 19(c), the second flexible wiring board 30 as the extension board was bonded to the first flexible wiring board 1. In bonding at this time, adhesion was performed using a nonconductive adhesive (not shown) and a method for bringing the wiring pattern 1 b of the first flexible wiring board 1 into direct contact with a wiring pattern of the second flexible wiring board 30 as the extension board and bringing the flexible wiring boards into conduction was adopted. Also, an adhesive strength of the solid-state imaging element 10 is reinforced by covering the solid-state imaging element substrate 10 with a molded resin 18. Then, a solid-state imaging apparatus is completed by placing a lens cabinet 16 in which an optical lens 15 is installed.

By adopting such a manufacturing method, a thin solid-state imaging apparatus with high rigidity, high accuracy, high reliability and high freedom in an extension cable can be manufactured simply.

Also, a flexible substrate and a reinforcing plate have the same outer shape dimension and form a laminated structure, and a notch or a reference hole in the case of installing an optical lens or a translucent member and a solid-state imaging element substrate is formed and a surface of the reinforcing plate is exposed to the side of the flexible wiring board in the periphery of the notch or the reference hole, so that the solid-state imaging element substrate and the translucent member can be placed using commonly its reference hole from the front and the back. Therefore, it is easy to thin a solid-state imaging apparatus and assembly can be done with good workability, and high rigidity and high accuracy of alignment of an optical axis can be obtained.

Also, in the embodiment described above, good imaging characteristics can be obtained by cutting an infrared region of light incident on the solid-state imaging element substrate when an optical filter is used as the translucent member.

Also, a thickness of the periphery of an opening part of the reinforcing plate in which the translucent member used in the solid-state imaging apparatus of the invention is placed may become thinner than the periphery. As a result of that, a positional deviation of the translucent member is eliminated and expansion of an adhesive for placement can also be suppressed.

In addition, it goes without saying that there is a necessity to align the solid-state imaging element substrate with the optical lens, and it is also important to align the translucent member with the solid-state imaging element substrate. This reason will be described.

Light emitted from the optical lens is designed to expand toward the solid-state imaging element substrate and it is constructed so as to emit the light from an exit pupil position exactly. As a result of this, a size of an optical filter constructed of the translucent member 14 requires a dimension in which an adhesion part is added to an opening of a plate-shaped member. Also, in a filter, a uniform film is formed in a vapor deposition apparatus, so that a work size (plate material before division) is limited and the work size is about 70 mm in angular size. Then, dicing and division is made by a diamond blade etc. in the case of forming products from the work size, so that a cost is determined by, that is, the number of products obtained from the work size. Hence, the cost can be reduced by minimizing a size including an adhesion area. Also, when a large filter is used, a solid-state imaging element overlaps with the filter in a plane. The center of the solid-state imaging element is called an effective imaging area and is a region in which light is actually photoelectrically converted into an electrical signal by a phototransistor (Tr), and there are a peripheral circuit etc. in the outside of this effective area and an electrode for wiring is disposed in its outside. Therefore, when the optical filter overlaps with a wiring part, the optical filter and the wiring part are respectively arranged in a thickness direction (optical axis direction), so that the thickness increases. From the above standpoint, it is desirable to use a small filter in order to achieve thinning and cost reduction and therefore, accuracy of the translucent member is required in order to surely cover an effective range of a light beam as described above.

Also, a light blocking film may be formed on a back surface of the solid-state imaging element substrate used in the solid-state imaging apparatus as described above, with the result that occurrence of noise by transmission of light from the back surface can be avoided in the case of a thin solid-state imaging element substrate.

This light blocking film may be a metal film formed on a back surface of the solid-state imaging element substrate. By this configuration, light from the back surface can be blocked more surely in a thin type.

Also, this light blocking film may be a light blocking resin film formed on a back surface of the solid-state imaging element substrate. By this configuration, formation is easy and light from the back surface can be blocked surely.

In addition, in the embodiment described above, an opening part is formed after a first flexible wiring board is pasted on a reinforcing plate, but by being cut by a laser etc. at this time, the edge of the flexible wiring board can be formed roundly and occurrence of wastes can be prevented and contamination of an imaging region can be prevented.

The invention described in the fifth and sixth embodiments has the following aspect.

That is, a solid-state imaging apparatus of the invention is characterized by comprising a laminated substrate constructed of a first flexible wiring board having an opening part and a reinforcing plate laminated and integrated with the first flexible wiring board, a translucent member placed in the side of the reinforcing plate of the laminated substrate so as to close an opening part, a solid-state imaging element substrate placed in the side of the first flexible wiring board of the laminated substrate, the reinforcing plate having an opening part, and a second flexible wiring board bonded to the first flexible wiring board.

By this configuration, it is easy to thin and miniaturize a solid-state imaging apparatus and assembly can be done with good workability, and high rigidity can be obtained.

Also, in the solid-state imaging apparatus described above, the invention includes a solid-state imaging apparatus wherein all the chip components other than the solid-state imaging element substrate are installed on a wiring pattern of the second flexible wiring board.

By this configuration, all the chip components other than the solid-state imaging element substrate are installed on the second flexible wiring board and the chip component is not installed on the first flexible wiring board which is a substrate in which the solid-state imaging element substrate is installed, so that the configuration has effects in which warpage of the first flexible wiring board or deterioration of the solid-state imaging element substrate by a reflow step does not occur and it is easy to mount the solid-state imaging element substrate and reduction in a step, improvement in design freedom and improvement in adaptability to repair can be obtained.

Also, in the solid-state imaging apparatus described above, the invention includes a solid-state imaging apparatus wherein the translucent member and an optical lens are attached to the side of the reinforcing plate and the optical lens and the solid-state imaging element substrate are aligned using a reference hole formed in the laminated substrate as a common reference from the front and the back.

By this configuration, a first flexible wiring board and a reinforcing plate have the same outer shape dimension and form a laminated structure, and a reference hole in the case of installing a translucent member (or an optical lens) and a solid-state imaging element substrate is formed and a surface of the reinforcing plate is exposed to the side of the flexible wiring board in the periphery of the reference hole and the solid-state imaging element substrate and the translucent member can be placed using commonly its reference hole from the front and the back. As a result, it is easy to thin a solid-state imaging apparatus and assembly can be done with good workability, and high rigidity and high accuracy of alignment of an optical axis can be obtained. As a result of that, a solid-state imaging apparatus capable of miniaturizing a mobile telephone etc. can be provided. The solid-state imaging element substrate herein refers to a substrate in which a solid-state imaging element is formed on a semiconductor substrate such as a silicon substrate, mainly a substrate divided into individual chips. Also, the reference hole includes the so-called notched part whose part is communicated to the outside as well as the so-called positioning hole whose peripheral edge is surrounded by a wall. Further, an outer shape, a wiring pattern, etc. using the reference hole as a reference may be used in alignment indirectly.

Also, in the solid-state imaging apparatus described above, the invention includes a solid-state imaging apparatus wherein the translucent member and an optical lens are attached to the side of the reinforcing plate and the optical lens and the solid-state imaging element substrate are aligned using a reference hole as a common reference from the front and the back. Furthermore, it is desirable to align the translucent member using this reference hole as the common reference.

An optical filter may be used as the translucent member used in the solid-state imaging apparatus of the invention. As a result of that, good imaging characteristics can be obtained by cutting an infrared region of light incident on a solid-state imaging element.

Also, a metal plate may be used as the reinforcing plate used in the solid-state imaging apparatus of the invention. As a result of that, high rigidity of the solid-state imaging apparatus can be obtained.

Also, the reinforcing plate made of a metal plate may be electrically connected to a ground part of a wiring pattern of the flexible wiring board used in the solid-state imaging apparatus of the invention. As a result of that, stability of electrical characteristics can be obtained.

Also, resin molding may be performed from a back surface of a solid-state imaging element substrate used in the solid-state imaging apparatus of the invention. As a result of that, a mounting strength of a chip component or the solid-state imaging element substrate can be reinforced.

Also, a light blocking film may be formed on a back surface of a solid-state imaging element substrate used in the solid-state imaging apparatus of the invention. As a result of that, occurrence of noise by transmission of light from the back surface can be avoided in the case of a thin solid-state imaging element substrate.

Also, in the solid-state imaging apparatus described above, the invention includes a solid-state imaging apparatus wherein a thickness of the periphery of an opening part of the reinforcing plate in which the translucent member is placed becomes thinner than the periphery.

Also, in the solid-state imaging apparatus described above, the invention includes a solid-state imaging apparatus wherein a connector is disposed on the second flexible wiring board.

Also, in the solid-state imaging apparatus described above, the invention includes a solid-state imaging apparatus wherein resin molding is performed on a back surface of the solid-state imaging element substrate.

Also, in the solid-state imaging apparatus described above, the invention includes a solid-state imaging apparatus wherein a light blocking film is formed on a back surface of the solid-state imaging element substrate.

Also, the light blocking film may be a metal film formed on a back surface of the solid-state imaging element substrate. By this configuration, light from the back surface can be blocked more surely in a thin type.

Also, the light blocking film may be a light blocking resin film formed on a back surface of the solid-state imaging element substrate. By this configuration, formation is easy and light from the back surface can be blocked surely.

Also, a manufacturing method of a solid-state imaging apparatus of the invention is characterized by comprising the steps of sticking a first flexible wiring board on a reinforcing plate, cutting an outer shape by press, installing a solid-state imaging element substrate so as to close an opening part of the first flexible substrate, installing a translucent member so as to close an opening part of the reinforcing plate, and bonding a second flexible wiring board to the first flexible wiring board. As a result, a thin and miniature solid-state imaging apparatus having high rigidity and high freedom in a shape of wiring extension can be manufactured simply.

Also, in the manufacturing method of the solid-state imaging apparatus described above, the invention includes a step of installing all the chip components other than the solid-state imaging element substrate and a connector on the second flexible wiring board prior to the step of bonding.

Also, in the invention in the manufacturing method of the solid-state imaging apparatus described above, a step of installing a solid-state imaging element substrate includes a step of forming a conductive adhesive layer in a bump of the solid-state imaging element substrate and also performing flip chip mounting in a flexible substrate and injecting a sealing resin into the periphery of a bonding part.

According to this configuration, a mounting method in which after a bump is formed in a wiring part of a solid-state imaging element substrate, a conductive adhesive is transferred to the bump and flip chip mounting is performed in a flexible substrate and electrical bonding is ensured by thermal curing and a sealing resin is injected into the periphery of a bonding part may be used. As a result of that, electrical characteristics with high reliability capable of coping with thermal deformation in a solid-state imaging element substrate installation part can be obtained.

By using the solid-state imaging apparatus of the invention and the manufacturing method thereof thus, the solid-state imaging apparatus can be thinned and miniaturized and the solid-state imaging apparatus having high rigidity can be manufactured simply. As a result of that, a portable terminal apparatus can also be thinned and miniaturized.

According to the invention, the solid-state imaging apparatus can be thinned and miniaturized and the solid-state imaging apparatus having high rigidity and the manufacturing method thereof can be provided simply.

A reinforcing adhesion structure of a flexible wiring board which is seventh to fourteenth embodiments according to the invention will hereinafter be described in detail with reference to the drawings.

### (Seventh embodiment)

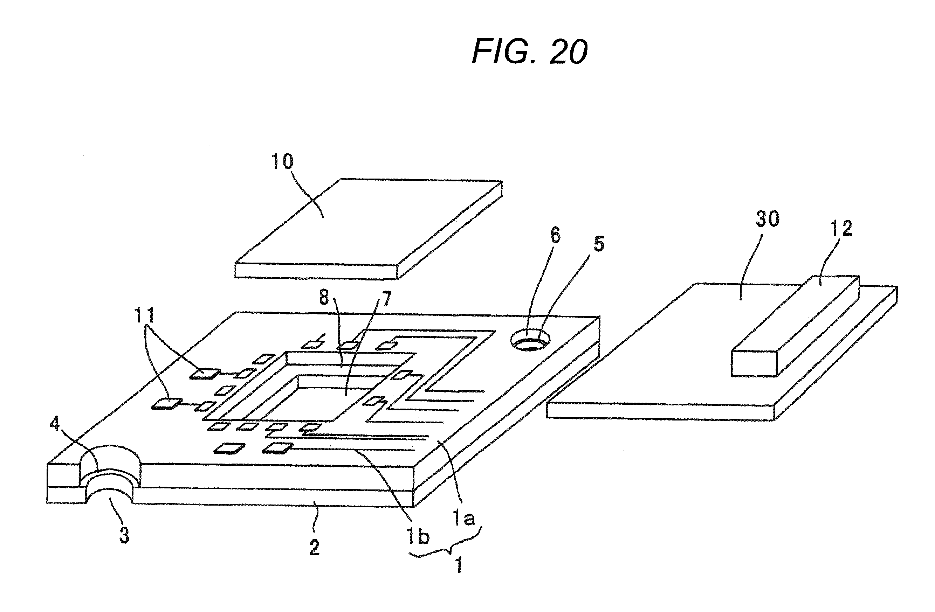

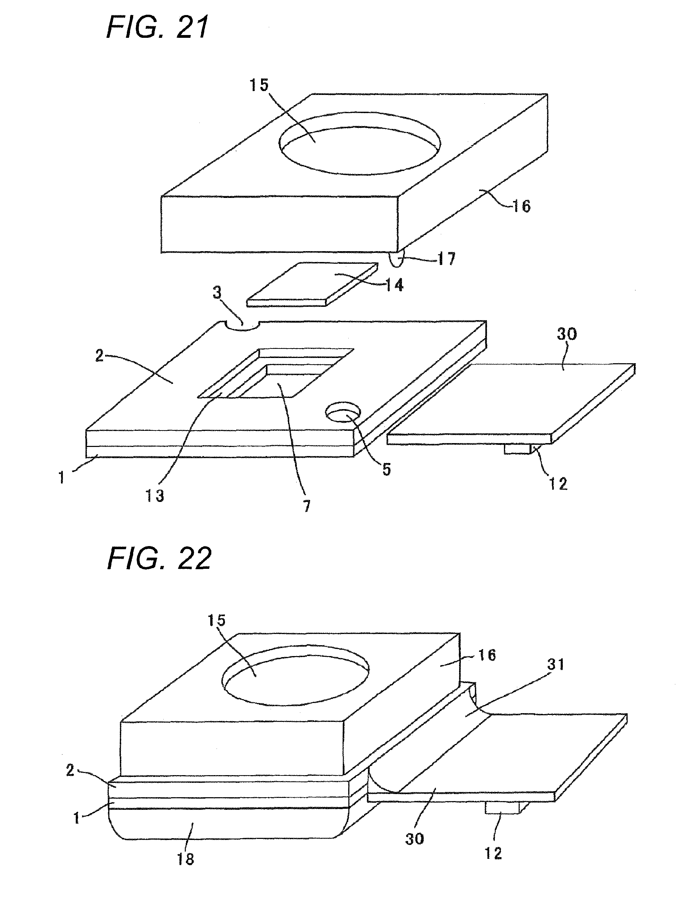

Fig. 20 is an exploded perspective view of a solid-state imaging apparatus of a seventh embodiment. Fig. 21 is an exploded perspective view of the solid-state imaging apparatus of the seventh embodiment, and Fig. 22 is a perspective view of the solid-state imaging apparatus of the seventh embodiment. Figs. 21 and 22 are perspective views in which Fig. 20 is seen from the back.

As shown in Figs. 20 to 22, a solid-state imaging apparatus of the invention is characterized by comprising a second flexible wiring board 30 bonded to a first flexible wiring board 1 and a reinforcing adhesion part 31 with which a bonding part between the first flexible wiring board and the second flexible wiring board 30 is covered. This reinforcing adhesion part 31 is formed so as to cover the periphery of the bonding part from a reinforcing plate 2 to the second flexible wiring board 30 as shown in Fig. 22.

That is, this solid-state imaging apparatus comprises a laminated substrate constructed of the first flexible wiring board 1 having an opening part and the reinforcing plate 2 laminated and integrated with this first flexible wiring board 1, an optical lens 15 and a translucent member 14 placed in the side of the reinforcing plate 2 of this laminated substrate so as to close the opening part, and a solid-state imaging element substrate 10 placed in the side of the first flexible wiring board 1 of this laminated substrate, and this reinforcing plate 2 comprises a positioning hole 5 and a notched part 3 as reference holes for placement of the solid-state imaging element substrate, and the reinforcing plate 2 is also exposed to the side of the flexible wiring board 1 in the peripheral edges of this notched part 3 and the positioning hole 5, and the solid-state imaging element substrate, the translucent member 14, the optical lens 15 and a lens cabinet 16 are arranged on both surfaces of the laminated substrate using these two reference holes as a common reference.

Also in this example, the flexible wiring board 1 having the opening part and the reinforcing plate 2 whose outer shape is the same size are laminated and integrated as shown in Fig. 20. In the flexible wiring board 1 of this case, a polyimide resin film with a thickness of 25 µm was used as a film base substance 1 a (base film) and a SUS plate with a thickness of 200 µm was used in the reinforcing plate 2. Then, in this flexible wiring board 1, a metal wiring pattern 1 b is formed on the film base substance 1 a. Further, the solid-state imaging element substrate 10 was placed on the first flexible wiring board 1 so as to make electrical connection. Then, the second flexible wiring board 30 as an extension board was electrically connected to the flexible wiring board 1. In connection of this case, adhesion was performed using a nonconductive adhesive and a method for bringing a wiring pattern of the first flexible wiring board 1 into direct contact with a wiring pattern (not shown) of the second flexible wiring board 30 as the extension board and bringing the flexible wiring boards into conduction was adopted. Then, the reinforcing adhesion part 31 was formed from the reinforcing plate 2 to the second flexible wiring board 30. A connector 12 is installed in the flexible wiring board 30 and connection to a wiring substrate (not shown) of a portable device body is made by this connector 12.

Also, a ground part of the metal wiring pattern 1 b is electrically connected to the SUS reinforcing plate 2. Further, a substrate in which a light blocking film (not shown) is applied to a back surface was used in the solid-state imaging element substrate 10 used at this time.

Then, the notched part 3 as the reference hole is formed in the reinforcing plate 2 and an exposed part 4 of the reinforcing plate is formed in the periphery of the notched part. Also, there is the positioning hole 5 as the reference hole and an exposed part 6 of the reinforcing plate 2 is formed in the periphery of the positioning hole. That is, in the notched part 3 and the positioning hole 5 as the reference holes, shapes formed in the reinforcing plate 2 can be recognized as the reference from both the front and the back. Then, an opening part 7 is opened and an exposed part 8 of the reinforcing plate 2 is formed in the periphery of the opening part. The metal wiring pattern 1b is formed in the flexible wiring board 1 and the solid-state imaging element substrate 10 is placed so as to make electrical connection. Chip components 11 are placed on the first flexible wiring board 1 so as to be connected to the metal wiring pattern 1b. Also, the ground part of the metal wiring pattern 1 b is electrically connected to the SUS reinforcing plate 2.

Further, a substrate in which a black epoxy resin film (not shown) is applied to a back surface as a light blocking film was used in the solid-state imaging element substrate 10 used at this time. In addition, a metal film such as a tungsten thin film formed on a back surface of the solid-state imaging element substrate 10 may be used as this light blocking film.

By having such a configuration, while utilizing a merit of thinness of the flexible substrate 1, high strength performance by the reinforcing plate 2 having the same outer shape can be ensured and further a close contact strength of a connection part between the mutual flexible wiring boards can be enhanced.

Also, the notched part 3 or the positioning hole 5 as the reference hole becomes the reference at the time of placing the solid-state imaging element substrate 10 and can also be used as the common reference at the time of placing the lens cabinet 16 in the opposite side, so that optical axes of the lens 15 and the solid-state imaging element substrate 10 can be aligned with high accuracy. By forming the exposed parts 4, 6 of the reinforcing plate, a deviation of the first flexible wiring board 1 or an obstacle (for example, a protrusion in an end face) to reference recognition can be avoided and a shape of a SUS end face with high accuracy can be ensured.

Also, the exposed part 8 of the reinforcing plate of the periphery of the opening part 7 similarly suppresses occurrence of a shield etc. with respect to an imaging area of the solid-state imaging element substrate 10 and the imaging area can be ensured with high accuracy. Freedom of electrical wiring design improves by installing the chip component 11 on a surface of the flexible wiring board 1. That is, the chip component can be placed in the vicinity of a solid-state imaging element and electrical characteristics can be optimized.

Also, by installing the connector 12 on the second flexible substrate 30, a signal from the solid-state imaging element substrate 10 can be fetched to the outside through the first flexible substrate 1 and the second flexible substrate 30 directly connected to this first flexible substrate, and connection to a portable device can be made freely. When the first flexible wiring board 1 is made larger than the reinforcing plate 2 and is used as flexible wiring as it is, a break in wiring by bending in a step part to the reinforcing plate 2 may be caused, so that it is preferable to be connected from a separated state thus. Also, since the metal wiring pattern 1b is electrically connected to the SUS reinforcing plate 2, noise suppression or electrostatic shielding can be performed, so that stability of electrical characteristics can be obtained. Further, a light blocking film made of a metal thin film such as tungsten is applied to a back surface of the solid-state imaging element substrate 10, so that noise of an imaging signal by light incidence from the back surface of the solid-state imaging element substrate 10 can be reduced.

By having such a configuration, high strength performance by the reinforcing plate 2 having the same outer shape can be ensured while utilizing a merit of thinness of the first flexible wiring board 1. Also, a connector shape and an extension cable shape with high freedom can be selected while utilizing original flexible characteristics by separately preparing the connector 12 for the second flexible wiring board 30. Also, since connection to the first flexible wiring board 1 can be made after checking whether trouble occurs at the time of mounting the connector 12, a situation in which the solid-state imaging apparatus including the expensive solid-state imaging element substrate 10 becomes NG due to occurrence of a defect in the connector 12 can be avoided, with the result that a cost can be reduced. Also, this solid-state imaging apparatus can easily be electrically connected to a portable device body using this connector. Also, since the metal wiring pattern 1b is electrically connected to the SUS reinforcing plate 2, noise suppression or electrostatic shielding can be performed, so that stability of electrical characteristics can be obtained. Further, a light blocking film is applied to a back surface of the solid-state imaging element substrate 10, so that noise of an imaging signal by light incidence from the back surface of the solid-state imaging element substrate 10 can be eliminated.

Fig. 21 is an exploded perspective view of the solid-state imaging apparatus of the seventh embodiment, and is the view in which the solid-state imaging apparatus of Fig. 20 is seen from a back surface.

The first flexible wiring board 1 and the reinforcing plate 2 whose outer shape is the same size are laminated and integrated, and the notched part 3 and the positioning hole 5 as the reference holes are formed. Then, the opening part 7 is also opened in the reinforcing plate 2 and a step part 13 thinner than the overall thickness of the reinforcing plate 2 is formed in the periphery of the opening part 7. The translucent member 14 is dropped into this step part 13 and is placed in the reinforcing plate 2. Glass having an infrared cut filter function was used in the translucent member 14. Then, a reference protrusion part 17 is formed in the lens cabinet 16 integrated with the optical lens 15. The illustrated reference protrusion part 17 is means fitted into the positioning hole 5 as the reference hole, and a reference protrusion fitted into the notched part 3 is not shown, but is similarly formed. Numeral 30 is the second flexible wiring board.

By having such a configuration, a positional deviation of the translucent member 14 is eliminated and the translucent member 14 can be glued to the step part 13 so as to close the opening part 7 while suppressing expansion of an adhesive for adhesion to an excessive area. Also, by fitting the reference protrusion part 17 of the lens cabinet 16 into the positioning hole 5 as the reference hole or as the notched part 3 as the reference hole, it can be set at the reference common to the opposite solid-state imaging element substrate 10, so that high-accuracy alignment of an optical axis can be performed.

Fig. 22 is an assembly perspective view of the solid-state imaging apparatus of the seventh embodiment, and is the view in which the solid-state imaging apparatus of Fig. 20 is seen from a back surface, and is the view seen from the same direction as the solid-state imaging apparatus of Fig. 21.

The first flexible wiring board 1 is electrically bonded to the second flexible wiring board 30, and the reinforcing adhesion part 31 is formed so as to cover a bonding part from the reinforcing plate 2 to the second flexible wiring board 30. Also, a resin mold 18 is formed so as to cover the chip components 11 and the solid-state imaging element substrate 10 installed on the first flexible wiring board 1.

By having such a configuration, a strength of the bonding part can be enhanced and reliability of the solid-state imaging apparatus can be enhanced more.

Also, by adopting such a configuration, component dropping of the solid-state imaging element substrate 10 or the chip component 11 is prevented and adhesion can be performed tightly. Further, by forming the molded resin 18 on a back surface of the solid-state imaging element substrate 10, noise by transmitted light from the back surface of the solid-state imaging element substrate 10 can be suppressed. In order to further suppress the transmitted light from the back surface of the solid-state imaging element substrate 10, a light blocking film may be formed on the back surface of the solid-state imaging element substrate 10 as described above. Intrusion of a shield into the notched part 3 as the reference hole can be eliminated by molding the molded resin 18 so as to ensure a molded resin notched part (not shown).

### (Eighth embodiment)

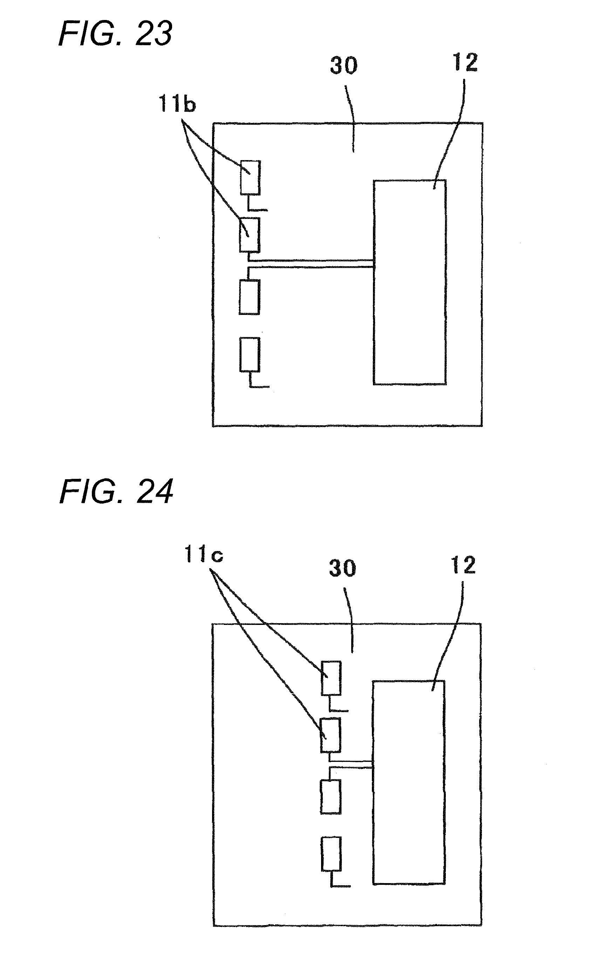

Fig. 23 is a plan view of a second flexible wiring board 30 of a solid-state imaging apparatus of an eighth embodiment. A solid-state imaging element substrate 10 is installed in only a first flexible substrate and chip components 11 b such as a resistor or a capacitor are installed in the second flexible wiring board. The chip components 11 b are placed in the inside beyond a bonding part to a first flexible wiring board 1.

As a result, the appearance has a configuration similar to that of Fig. 22 and though the chip components 11 b are installed in the flexible wiring board different from the solid-state imaging element substrate 10, all the components can be molded of resin by a resin mold 18 (not shown).

### (Ninth embodiment)

Fig. 24 is a plan view of a second flexible wiring board 30 of a solid-state imaging apparatus of a ninth embodiment. A solid-state imaging element substrate 10 is installed in only a first flexible substrate and chip components 11c are installed in the second flexible wiring board 30. The chip components 11c are placed in the outside beyond a bonding part to a first flexible wiring board 1.

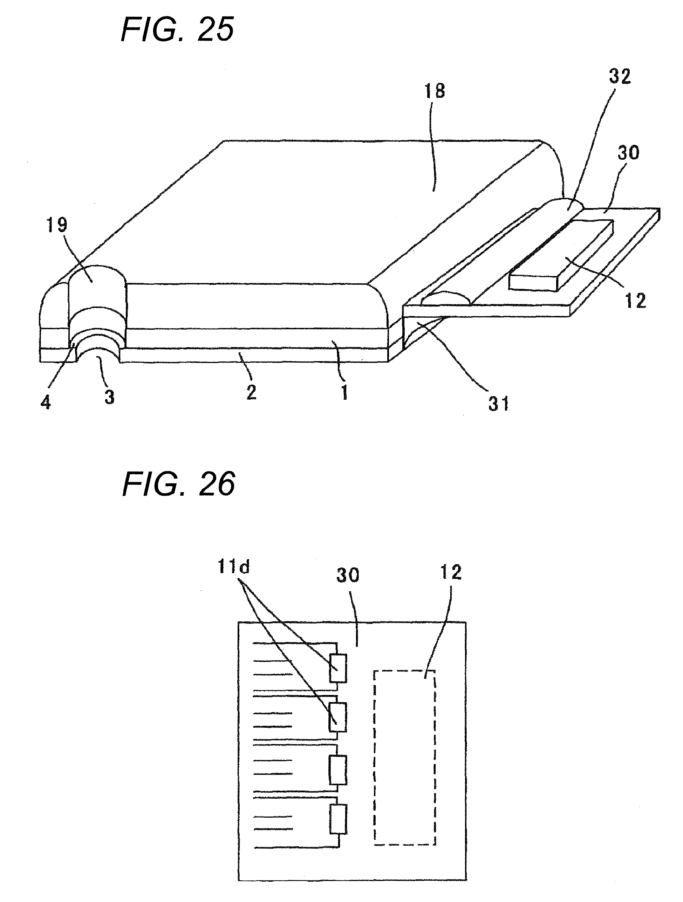

Fig. 25 is an assembly perspective view of the solid-state imaging apparatus of the ninth embodiment. The chip components 11 c in Fig. 24 are covered with a second molded resin 32.

By adopting such a configuration, the mutual flexible wiring boards can be electrically bonded after the components 11c separately installed on the second flexible wiring board are previously covered with the second resin mold, so that close contact between the components can be made more tightly or only a flexible wiring board capable of checking electrical bonding and installation of a connector and a component can be checked before bonding. Therefore, the expensive solid-state imaging element substrate 10 is not wasted due to a defect in a connector 12 and the components 11c after bonding and a cost can be reduced.

In addition, in a manner similar to the seventh embodiment in the present embodiment, a molded resin 18 is molded so as to ensure a molded resin notched part 19 and by this configuration, intrusion of a shield into a notched part 3 as a reference hole can be eliminated.

### (Tenth embodiment)

Fig. 26 is a plan view of a second flexible wiring board 30 of a solid-state imaging apparatus of a tenth embodiment. A solid-state imaging element substrate 10 is installed in only a first flexible substrate and chip components 11 d are installed in the second flexible wiring board 30. The chip components 11 d are installed in the side opposite to a connector 12.

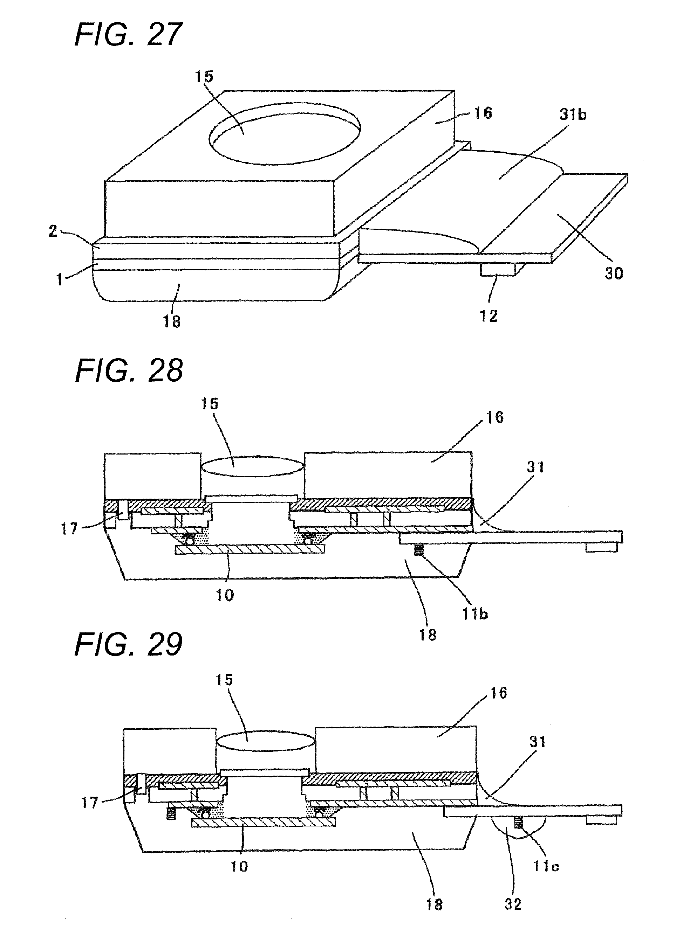

Fig. 27 is an assembly perspective view of the solid-state imaging apparatus of the tenth embodiment. The chip components 11 d in Fig. 26 are covered with a reinforcing adhesion part 31 b.

By such a configuration, while performing reinforcing adhesion, the components 11 d can be covered and while enhancing a strength of close contact between the components 11 d, a step can be simplified.

### (Eleventh embodiment)

Next, a manufacturing method of a solid-state imaging apparatus of an eleventh embodiment will be described.

Since both of formation of a laminated substrate and mounting using this are substantially similar to the steps described in the fourth embodiment, the description is herein omitted.

In a manner similar to the second, fourth and sixth embodiments, vias are bored in a flexible base material 1 a constructing a flexible wiring board 1, and wiring of wiring patterns 1 b made of metal layers is formed on both surfaces, and a reinforcing plate 2 is stuck on the whole surface, and after lamination and integration, the outer shape is cut off in individual pieces by press cutting, and an opening part 7 and a notched part 3 or a positioning hole 5 as a reference hole are bored by etching and also, exposed parts 4, 6 of the reinforcing plate are ensured in the peripheries of the hole parts and further, a step part 13 for installing a translucent member is formed in the side of the reinforcing plate 2 of the opening part 7, and a laminated substrate as a mounting substrate for solid-state imaging apparatus is fabricated.

Then, using the laminated substrate formed in this manner, a chip component 11 is installed and a translucent member 14 is glued to the step part 13 of the reinforcing plate 2 and a solid-state imaging element substrate 10 is placed on the wiring patterns 1 b of the flexible wiring board 1 so as to close the opening part as opposed to the translucent member 14. Then, in order to reinforce a connection part, a sealing resin 9 was injected and was heated and cured.

Then, a second flexible wiring board 30 as an extension board was bonded to the first flexible wiring board 1. In bonding at this time, a nonconductive adhesive (not shown) was used and a method for bringing the wiring pattern 1b of the first flexible wiring board 1 into direct contact with a wiring pattern of the second flexible wiring board 30 as the extension board and bringing the flexible wiring boards into conduction was adopted. Then, a molded resin 18 is formed so as to cover a bonding part between the first flexible wiring board 1 and the second flexible wiring board 30. At this time, the solid-state imaging element substrate 10 and the chip component 11 are also covered. Further, a reinforcing adhesion part 31 is formed so as to cover the periphery of a connection part from the reinforcing plate 2 to the second flexible wiring board 30. Then, a solid-state imaging apparatus is completed by placing a lens cabinet 16 in which an optical lens 15 is installed.

By adopting such a manufacturing method, a thin solid-state imaging apparatus with high rigidity, high accuracy, high reliability and further high freedom in an extension cable can be manufactured simply since a close contact strength of a connection part between the mutual flexible wiring boards can be enhanced.

Also, the close contact strength of the connection part can be ensured more by forming the reinforcing adhesion part 31 so as to cover the periphery of the connection part from the reinforcing plate 2 to the second flexible wiring board 30 in the solid-state imaging apparatus of the invention.

Also, a mounting strength of a chip component or a solid-state imaging element can be reinforced by being covered with the molded resin 18 from a back surface of a solid-state imaging element substrate.

Also, a flexible substrate and a reinforcing plate have the same outer shape dimension and form a laminated structure, and a notch or a reference hole in the case of installing an optical lens or a translucent member and a solid-state imaging element substrate is formed and a surface of the reinforcing plate is exposed to the side of the flexible wiring board in the periphery of the notch or the reference hole and the solid-state imaging element substrate and the translucent member can be placed using commonly its reference hole from the front and the back. Therefore, it is easy to thin a solid-state imaging apparatus and assembly can be done with good workability, and high rigidity and high accuracy of alignment of an optical axis can be obtained.

In addition, this hole may not be a through hole or may be a notch.

Also, in the embodiment described above, good imaging characteristics can be obtained by cutting an infrared region of light incident on the solid-state imaging element substrate when an optical filter is used as the translucent member.

Also, a thickness of the periphery of an opening part of the reinforcing plate in which the translucent member used in the solid-state imaging apparatus of the invention is placed may become thinner than the periphery. As a result of that, a positional deviation of the translucent member is eliminated and expansion of an adhesive for placement can also be suppressed.

Also, a light blocking film may be formed on a back surface of the solid-state imaging element substrate used in the solid-state imaging apparatus as described above, with the result that occurrence of noise by transmission of light from the back surface can be avoided in the case of a thin solid-state imaging element substrate.

This light blocking film may be a metal film formed on a back surface of the solid-state imaging element substrate. By this configuration, light from the back surface can be blocked more surely in a thin type.

Also, this light blocking film may be a light blocking resin film formed on a back surface of the solid-state imaging element substrate. By this configuration, formation is easy and light from the back surface can be blocked surely.

In addition, in the embodiment described above, an opening part is formed after a first flexible wiring board is pasted on a reinforcing plate, but by being cut by a laser etc. at this time, the edge of the flexible wiring board can be formed roundly and occurrence of wastes can be prevented and contamination of an imaging region can be prevented.

### (Twelfth embodiment)

Fig. 28 is a sectional view showing a manufacturing method of a solid-state imaging apparatus of a twelfth embodiment. This is the view corresponding to Fig. 14(c).

Only a solid-state imaging element substrate 10 is installed in a first flexible wiring board 1, and components 11b other than the solid-state imaging element substrate 10 are installed in a top part of a second flexible substrate 30.

Through a manufacturing method similar to the manufacturing method shown in the eleventh embodiment, a position of the components 11 b deviates from a connection part between the first flexible wiring board 1 and the second flexible wiring board 30, so that the components are not influenced at the time of thermal compression bonding of the connection part. Thereafter, a close contact strength of all the components can be enhanced by simultaneously covering the components 11 b installed in the top part of the second flexible wiring board 30 at a stage of forming a resin mold 18.

By adopting such a manufacturing method, the close contact strength can be enhanced by collectively integrating the installed components.

### (Thirteenth embodiment)

Fig. 29 is a sectional view showing a manufacturing method of a solid-state imaging apparatus of a thirteenth embodiment. This is the view corresponding to Fig. 14(c).

Components other than a solid-state imaging element substrate 10 are not installed in a first flexible wiring board 1, and the other components 11c are installed in the middle of a second flexible substrate 30.

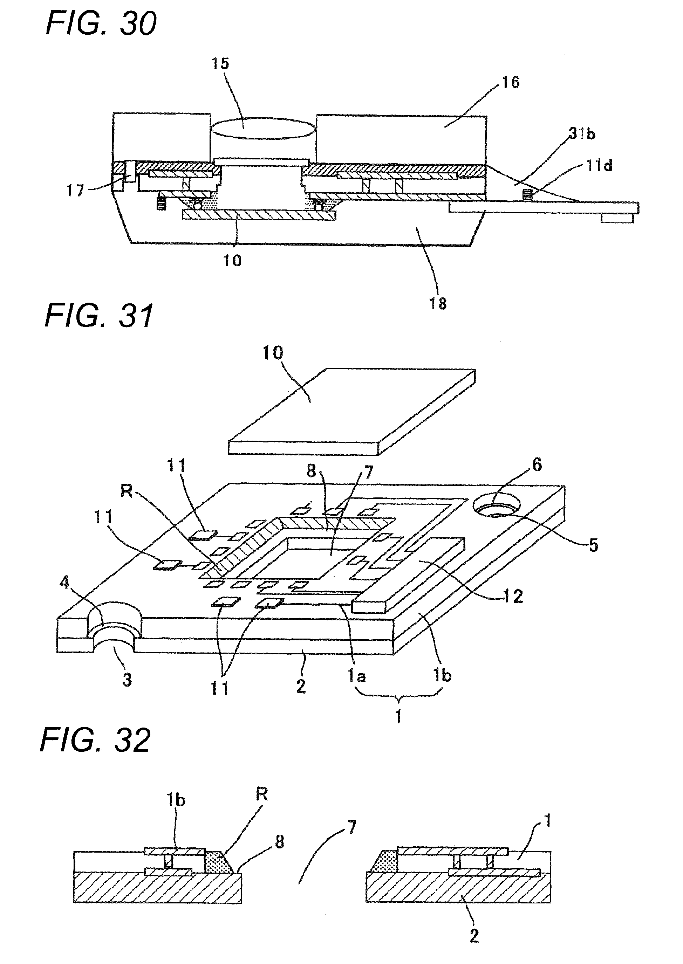

Through a manufacturing method similar to the manufacturing method of the eleventh embodiment shown in Figs. 30 and 31, the components 11 c are covered with a second molded resin 32 before the first flexible wiring board 1 is connected to the second flexible wiring board 30. Since a position of the components 11c deviates from a connection part between the flexible wiring boards, the components are not influenced at the time of thermal compression bonding of the connection part. Thereafter, connection is made by thermal compression bonding and a resin mold 18 is formed and a reinforcing adhesion part 31 of the connection part is formed.

By adopting such a manufacturing method, a close contact strength of all the components can be enhanced. Also, only the second flexible wiring board is separately formed in a state of enhancing the lose contact strength of the components singly and connection is made after checking a conforming product and improvement in a yield or ensuring of a strength of individual components can be obtained.

In addition, it goes without saying that molding may be performed so that an integrated resin mold is constructed so as to cover the whole components as described in the twelfth embodiment by extending the resin mold 18 without forming the resin mold 32 individually previously.

### (Fourteenth embodiment)

Fig. 30 is a sectional view showing a manufacturing method of a solid-state imaging apparatus of a fourteenth embodiment. This is the view corresponding to Fig. 14(c).

Components other than a solid-state imaging element substrate 10 are not installed in a first flexible wiring board 1, and the other components 11 d are installed in a surface opposite to a connector 12 of a second flexible substrate 30.

Through a manufacturing method similar to the manufacturing method of the eleventh embodiment shown in Figs. 30 and 31, the first flexible wiring board 1 is connected to the second flexible wiring board 30 by thermal compression bonding. Since a position of the components 11 d deviates from a connection part between the flexible wiring boards, the components are not influenced at the time of thermal compression bonding of the connection part. Thereafter, a reinforcing adhesion part 31 b of the connection part is formed so as to also cover the components 11 d.

By adopting such a manufacturing method, a close contact strength of all the components can be enhanced. Also, the components 11 d can be covered simultaneously at the time of forming the reinforcing adhesion part 31 b, so that the number of man-hours can be reduced.

The invention described in the seventh to fourteenth embodiments has the following aspect.

That is, a solid-state imaging apparatus of the invention is characterized by comprising a first flexible wiring board having an opening part, a reinforcing plate having an opening part coinciding with the opening part and laminated to the first flexible wiring board, a translucent member attached to the side of the reinforcing plate so as to close the opening part, a solid-state imaging element substrate attached to the side of the flexible wiring board, a second flexible wiring board bonded to the first flexible wiring board, and a reinforcing adhesion part with which the periphery of a bonding part is covered from the reinforcing plate to the second flexible wiring board.

By this configuration, the solid-state imaging apparatus has high rigidity in spite of the thin and miniature apparatus, and an adhesive strength of a connection part between the mutual flexible wiring boards can be enhanced. Also, this configuration has an effect capable of having high freedom in a shape of wiring extension.

Also, in the solid-state imaging apparatus described above, the invention includes a solid-state imaging apparatus wherein a component is installed on the first flexible wiring board and a resin molded part is formed so as to cover the component.

By this configuration, adhesion properties of the component can be enhanced more and reliability can be improved. In addition, the component herein includes a chip component, a solid-state imaging element chip (a solid-state imaging element substrate), etc.

Also, in the solid-state imaging apparatus described above, the invention includes a solid-state imaging apparatus wherein a solid-state imaging element substrate is installed on the first flexible wiring board and a component other than the solid-state imaging element substrate is installed in the second flexible wiring board.

At this time, the case where only the solid-state imaging element substrate is installed on the first flexible wiring board and the other components are installed in the second flexible wiring board is also included. Further, the case of also covering a component on the second flexible wiring board with a resin mold is included. Further, a component on the first flexible wiring board and a component on the second flexible substrate may be individually covered with a resin mold. That is, the case where the component on the first flexible wiring board is covered with a first resin mold and the component on the second flexible substrate is covered with a second resin mold is also included.

Also, in the solid-state imaging apparatus described above, the invention includes a solid-state imaging apparatus wherein in the side of the reinforcing plate, the translucent member and an optical lens are oppositely placed in a state of sandwiching the opening part.

Also, in the solid-state imaging apparatus described above, the invention includes a solid-state imaging apparatus wherein the translucent member and an optical lens are attached to the side of the reinforcing plate and the optical lens and the solid-state imaging element substrate are aligned using a reference hole formed in the laminated substrate as a common reference from the front and the back.

By this configuration, a first flexible wiring board and a reinforcing plate have the same outer shape dimension and form a laminated structure, and a reference hole in the case of installing a translucent member (or an optical lens) and a solid-state imaging element substrate is formed and a surface of the reinforcing plate is exposed to the side of the flexible wiring board in the periphery of the reference hole and the solid-state imaging element substrate and the translucent member can be placed using commonly its reference hole from the front and the back. As a result, it is easy to thin a solid-state imaging apparatus and assembly can be done with good workability, and high rigidity and high accuracy of alignment of an optical axis can be obtained. As a result of that, a solid-state imaging apparatus capable of miniaturizing a mobile telephone etc. can be provided. The solid-state imaging element substrate herein refers to a substrate in which a solid-state imaging element substrate is formed on a semiconductor substrate such as a silicon substrate, mainly a substrate divided into individual chips. Also, the reference hole includes the so-called notched part whose part is communicated to the outside as well as the so-called positioning hole whose peripheral edge is surrounded by a wall. Further, an outer shape, a wiring pattern, etc. using the reference hole as a reference may be used in alignment indirectly.

Also, in the solid-state imaging apparatus described above, the invention includes a solid-state imaging apparatus wherein the translucent member and an optical lens are attached to the side of the reinforcing plate and the optical lens and the solid-state imaging element substrate are aligned using a reference hole as a common reference from the front and the back. Furthermore, it is desirable to align the translucent member using this reference hole as the common reference.

An optical filter may be used as the translucent member used in the solid-state imaging apparatus of the invention. As a result of that, good imaging characteristics can be obtained by cutting an infrared region of light incident on a solid-state imaging element.

Also, a metal plate may be used as the reinforcing plate used in the solid-state imaging apparatus of the invention. As a result of that, high rigidity of the solid-state imaging apparatus can be obtained.

Also, the metal reinforcing plate may be electrically connected to a ground part of a wiring pattern of the flexible wiring board used in the solid-state imaging apparatus of the invention. As a result of that, stability of electrical characteristics can be obtained.

Also, a light blocking film may be formed on a back surface of a solid-state imaging element substrate used in the solid-state imaging apparatus of the invention. As a result of that, occurrence of noise by transmission of light from the back surface can be avoided in the case of a thin solid-state imaging element substrate.

Also, in the solid-state imaging apparatus described above, the invention includes a solid-state imaging apparatus wherein a thickness of the periphery of an opening part of the reinforcing plate in which the translucent member is placed becomes thinner than the periphery.

Also, in the solid-state imaging apparatus described above, the invention includes a solid-state imaging apparatus wherein a connector is disposed on the second flexible wiring board.

Also, in the solid-state imaging apparatus described above, the invention includes a solid-state imaging apparatus wherein resin molding is performed in the solid-state imaging element substrate and other installed component.

Also, in the solid-state imaging apparatus described above, the invention includes a solid-state imaging apparatus wherein a light blocking film is formed on a back surface of the solid-state imaging element substrate.

Also, the light blocking film may be a metal film formed on a back surface of the solid-state imaging element substrate. By this configuration, light from the back surface can be blocked more surely in a thin type.

Also, the light blocking film may be a light blocking resin film formed on a back surface of the solid-state imaging element substrate. By this configuration, formation is easy and light from the back surface can be blocked surely.

Also, a manufacturing method of a solid-state imaging apparatus of the invention is characterized by comprising the steps of sticking a first flexible wiring board on a reinforcing plate, cutting an outer shape by press, installing a solid-state imaging element substrate so as to close an opening part of the first flexible substrate, installing a translucent member so as to close an opening part of the reinforcing plate, bonding a second flexible wiring board to the first flexible wiring board, and performing resin molding so as to cover a bonding part between the first flexible wiring board and the second flexible wiring board and the solid-state imaging element substrate.

By this configuration, a shape processing with high accuracy can be performed easily, and a thin and miniature solid-state imaging apparatus having high rigidity and high freedom in a shape of wiring extension can be manufactured simply.

Also, as a method for installing a solid-state imaging element substrate in the manufacturing method of the solid-state imaging apparatus of the invention, a mounting method in which after a bump is formed in a wiring part of a solid-state imaging element substrate, a conductive adhesive is transferred to the bump and flip chip mounting is performed in a flexible substrate and electrical bonding is ensured by thermal curing and a sealing resin is injected into the periphery of a bonding part may be used. As a result of that, electrical characteristics with high reliability capable of coping with thermal deformation in a solid-state imaging element substrate installation part can be obtained.

By using the solid-state imaging apparatus of the invention and the manufacturing method thereof thus, the solid-state imaging apparatus can be thinned and miniaturized and the solid-state imaging apparatus having high rigidity can be manufactured simply. As a result of that, a portable terminal apparatus can also be thinned and miniaturized.

According to the configuration described above, a reinforcing plate and a first flexible wiring board having opening parts are laminated and integrated with the outer shapes equalized and also a translucent member and a solid-state imaging element substrate are oppositely placed so as to close the opening parts and a second flexible wiring board is bonded to the first flexible wiring board and a reinforcing adhesion part with which the periphery of a bonding part is covered from the reinforcing plate to the second flexible wiring board is disposed, so that the solid-state imaging apparatus can be thinned and miniaturized and a close contact strength of a connection part between the mutual flexible substrates can be enhanced and the solid-state imaging apparatus having high rigidity and the manufacturing method thereof can be provided simply. Also, this reinforcing adhesion part shares a resin mold with which a component installed in the second flexible wiring board is covered and thereby, the solid-state imaging apparatus with high reliability and high rigidity while maintaining thinning can be implemented.

A dust suppression structure which is fifteenth to nineteenth embodiments according to the invention will hereinafter be described in detail with reference to the drawings.

### (Fifteenth embodiment)

Fig. 31 is an exploded perspective view of a solid-state imaging apparatus of a fifteenth embodiment.

As shown in Fig. 31, a flexible wiring board 1 and a reinforcing plate 2 are laminated and integrated. In the flexible wiring board 1 of this case, a polyimide resin film with a thickness of 25 µm was used as a film base substance 1 a (base film) and a SUS plate with a thickness of 150 µm was used in the reinforcing plate 2. An opening part 7 is opened in the flexible wiring board 1 and the reinforcing plate 2 and an area of the opening part 7 of the reinforcing plate 2 is small and there is an exposed part 8 of the reinforcing plate with respect to the flexible wiring board 1. Then, a resin part R is formed so as to cover an end face of the opening part 3 of the flexible wiring board 1. This state is shown in Fig. 32.

Fig. 32 is a partially sectional view of the solid-state imaging apparatus of the fifteenth embodiment. The same numerals were assigned to the same members. The flexible wiring board 1 and the reinforcing plate 2 are laminated and integrated, and the area of the opening part 7 of the reinforcing plate 2 is smaller than that of the flexible wiring board 1 and there is the exposed part 8 of the reinforcing plate with respect to the flexible wiring board 1. Then, the resin part R is formed so as to cover the end face of the opening part 7 of the flexible wiring board 1. A metal wiring pattern 1 b is formed in the flexible wiring board 1.

Then, as shown in Fig. 31, a chip component 11 or a connector 12 was placed on the flexible wiring board 1 so as to be connected to the metal wiring pattern 1 b. Further, a solid-state imaging element substrate 10 was electrically connected and placed so as to close the opening part 7 of the flexible wiring board 1 and a translucent member (not shown) was placed so as to close the opening part 7 of the reinforcing plate 2 as opposed to the solid-state imaging element substrate 10. Also, a ground part of the metal wiring pattern 1b is electrically connected to the SUS reinforcing plate 2. Further, a substrate in which a black light blocking film (not shown) is applied to a back surface was used in the solid-state imaging element substrate 10 used at this time.

By having such a configuration, high strength performance by the reinforcing plate 2 can be ensured while utilizing a merit of thinness of the flexible wiring board 1. Also, since an end face of the opening part 7 of the flexible wiring board 1 is covered with the resin part R, burrs, chips, resin powder, etc. do not occur from the end face of the opening of the flexible wiring board 1 and the dust does not drop on a light receiving surface of a solid-state imaging element, so that occurrence of a black point video defect can be suppressed. As a result of that, a thin solid-state imaging apparatus having high rigidity and a small dust defect can be provided. Also, since the metal wiring pattern 1b is electrically connected to the SUS reinforcing plate 2, noise suppression or electrostatic shielding can be performed and stability of electrical characteristics can be obtained. Further, a light blocking film is applied to a back surface of the solid-state imaging element substrate 10, so that noise of an imaging signal by light incidence from the back surface of the solid-state imaging element substrate 10 can be eliminated.

In addition, optical characteristics may be enhanced using an optical filter as a translucent member 14. Also, freedom of electrical wiring design can be improved by installing the chip component 11 on a surface of the flexible wiring board 1 and the chip component can be placed in the vicinity of the solid-state imaging element substrate and electrical characteristics can be optimized. Also, by installing the connector 12 on the flexible wiring board 1, a signal from the solid-state imaging element substrate 10 can be fetched to the outside and connection to a portable device can be made freely.

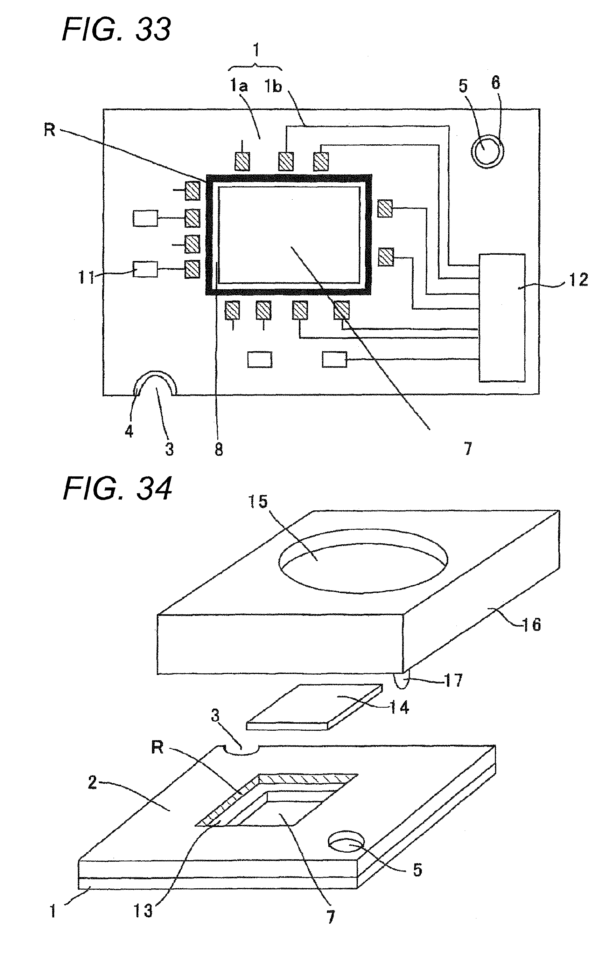

Further, in the embodiment, the flexible wiring board 1 and the reinforcing plate 2 with the same size and outer shape are laminated and pasted and thereby are integrated. In the flexible wiring board 1 of this case, a polyimide resin film with a thickness of 25 µm was used as a film base substance (base film) 1 a and a SUS plate with a thickness of 150 µm was used in the reinforcing plate 2. Then, a notched part 3 as a reference hole is formed in the reinforcing plate 2 and an exposed part 4 of the reinforcing plate is formed in the periphery of the notched part. Also, there is a positioning hole 5 as a reference hole and an exposed part 6 of the reinforcing plate 2 is formed in the periphery of the positioning hole. That is, in the notched part 3 and the positioning hole 5 as the reference holes, shapes formed in the reinforcing plate 2 can be recognized as the reference from both the front and the back. Then, an opening part 7 is opened and an exposed part 8 of the reinforcing plate 2 is formed in the periphery of the opening part. Also, as shown by a top view in Fig. 33, in this flexible wiring board 1, a metal wiring pattern 1 b is formed on the film base substance 1 a and the solid-state imaging element substrate 10 is placed so as to make electrical connection. A chip component 11 or a connector 12 is placed on the flexible wiring board 1 so as to be connected to the metal wiring pattern 1 b. Also, a ground part of the metal wiring pattern 1b is electrically connected to the SUS reinforcing plate 2. Further, a substrate in which a black epoxy resin film (not shown) is applied to a back surface as a light blocking film was used in the solid-state imaging element substrate 10 used at this time. In addition, a metal film such as a tungsten thin film formed on a back surface of the solid-state imaging element substrate 10 may be used as this light blocking film.

By having such a configuration, high strength performance by the reinforcing plate 2 having the same outer shape can be ensured while utilizing a merit of thinness of the flexible substrate 1. Also, the notched part 3 or the positioning hole 5 as the reference hole becomes the reference at the time of placing the solid-state imaging element substrate 10 and can also be used as the common reference at the time of placing a lens cabinet (not shown) in the opposite side, so that optical axes of a lens (not shown) and the solid-state imaging element substrate 10 can be aligned with high accuracy. By forming the exposed part 4 of the reinforcing plate, a deviation of the flexible wiring board 1 or an obstacle (for example, a protrusion in an end face) to reference recognition can be avoided and a shape of a SUS end face with high accuracy can be ensured. Also, the exposed part 8 of the reinforcing plate of the periphery of the opening part 7 similarly suppresses occurrence of a shield etc. with respect to an imaging area of the solid-state imaging element substrate 10 and the imaging area can be ensured with high accuracy. Freedom of electrical wiring design improves by installing the chip component 11 on a surface of the flexible wiring board 1. That is, the chip component can be placed in the vicinity of the solid-state imaging element substrate and electrical characteristics can be optimized. Also, by installing the connector 12 on the flexible substrate 1, a signal from the solid-state imaging element substrate 10 can be fetched to the outside and connection to a portable device can be made freely. When the flexible wiring board 1 is made larger than the reinforcing plate 2 and is used as flexible wiring as it is, a strength shortage in a step part to the reinforcing plate 2 is caused. In this case, another flexible wiring board may be directly connected instead of the connector 12. Also, since the metal wiring pattern 1b is electrically connected to the SUS reinforcing plate 2, noise suppression or electrostatic shielding can be performed, so that stability of electrical characteristics can be obtained. Further, a light blocking film made of a metal thin film such as tungsten is applied to a back surface of the solid-state imaging element substrate 10, so that noise of an imaging signal by light incidence from the back surface of the solid-state imaging element substrate 10 can be eliminated.

Fig. 34 is an exploded perspective view of the solid-state imaging apparatus of the fifteenth embodiment, and is the view in which the solid-state imaging apparatus of Fig. 31 is seen from a back surface.

The flexible wiring board 1 and the reinforcing plate 2 whose outer shape is the same size are laminated and integrated, and the notched part 3 and the positioning hole 5 as the reference holes are formed. Then, the opening part 7 is also opened in the reinforcing plate 2 and a step part 13 thinner than the overall thickness of the reinforcing plate 2 is formed in the periphery of the opening part 7. The translucent member 14 is dropped into this step part 13 and is placed in the reinforcing plate 2. Glass having an infrared cut filter function was used in the translucent member 14. Then, a reference protrusion part 17 is formed in the lens cabinet 16 integrated with the optical lens 15. The illustrated reference protrusion part 17 is means fitted into the positioning hole 5 as the reference hole, and a reference protrusion fitted into the notched part 3 is not shown, but is similarly formed.

By having such a configuration, a positional deviation of the translucent member 14 is eliminated and the translucent member 14 can be glued to the step part 13 so as to close the opening part 7 while suppressing expansion of an adhesive for adhesion to an excessive area. Also, by fitting the reference protrusion part 17 of the lens cabinet 16 into the positioning hole 5 as the reference hole or as the notched part 3 as the reference hole, it can be set at the reference common to the opposite solid-state imaging element substrate 10, so that high-accuracy alignment of an optical axis can be performed.

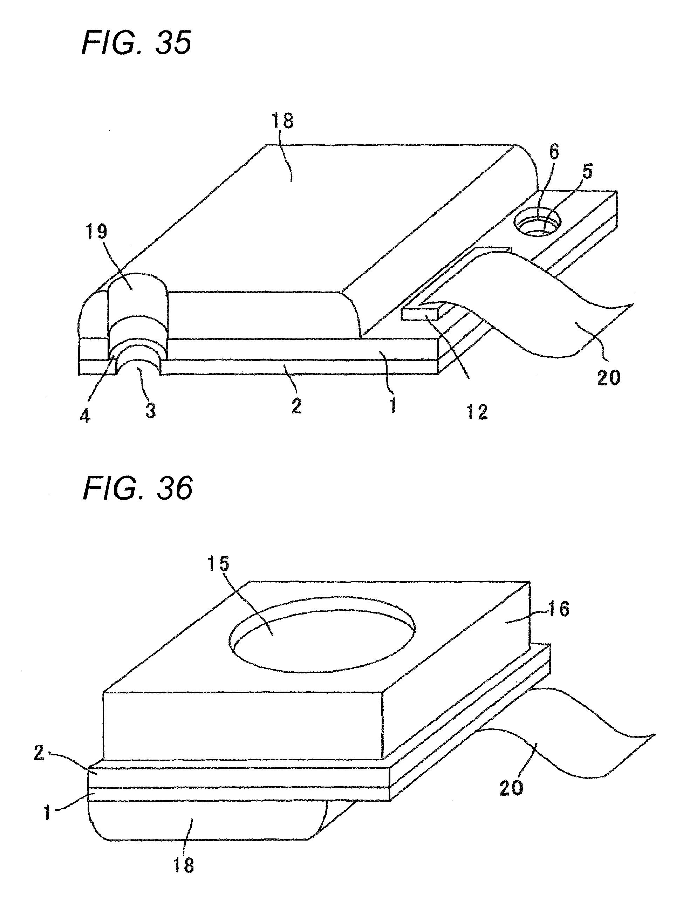

Fig. 35 is a perspective view of the solid-state imaging apparatus of the fifteenth embodiment, and is the view seen from the same side as Fig. 31.

The flexible wiring board 1 and the reinforcing plate 2 whose outer shape is the same size are laminated and integrated, and the notched part 3 as the reference hole and the positioning hole 5 as the reference hole are formed. Further, a molded resin 18 is formed so as to cover the solid-state imaging element substrate 10 and the chip component 11. A molded resin notched part 19 is formed so as to avoid the notched part 3 as the reference hole. Also, a wiring cable 20 made of a flat cable is pulled out of the connector 12.

By adopting such a configuration, component dropping of the solid-state imaging element substrate 10 or the chip component 11 is prevented and adhesion can be performed tightly. Also, by forming the molded resin 18 on a back surface of the solid-state imaging element substrate 10, noise by transmitted light from the back surface of the solid-state imaging element substrate 10 can be suppressed. In order to further suppress the transmitted light from the back surface of the solid-state imaging element substrate 10, a light blocking film may be formed on the back surface of the solid-state imaging element substrate 10 as described above. Intrusion of a shield into the notched part 3 as the reference hole can be eliminated by molding the molded resin 18 so as to ensure the molded resin notched part 19. Also, by being molded so as to avoid the connector 12, the wiring cable 20 can be attached after the lens cabinet 16 is installed. When the wiring cable 20 is previously attached, connection of the wiring cable may be reinforced by being molded to the wiring cable 20 and the connector 12 while avoiding the positioning hole 5 as the reference hole.

Fig. 36 is a perspective view of the solid-state imaging apparatus of the fifteenth embodiment, and is the view seen from the same side as Fig. 34.

The lens cabinet 16 is installed from the above of the reinforcing plate 2 and the flexible wiring board 1 in which the molded resin 18 is formed. Since the same reference as placement of the solid-state imaging element substrate 10 is used, high-accuracy alignment of an optical axis can be performed.

Also, a mounting strength of a chip component or a solid-state imaging element substrate can be reinforced by being covered with the molded resin 18 from a back surface of the solid-state imaging element substrate in the solid-state imaging apparatus of the invention.

According to this configuration, a flexible substrate and a reinforcing plate have the same outer shape dimension and form a laminated structure, and a notch or a reference hole in the case of installing an optical lens or a translucent member and a solid-state imaging element substrate is formed and a surface of the reinforcing plate is exposed to the side of the flexible wiring board in the periphery of the notch or the reference hole and the solid-state imaging element substrate and the translucent member can be placed using commonly its reference hole from the front and the back. Therefore, it is easy to thin a solid-state imaging apparatus and assembly can be done with good workability, and high rigidity and high accuracy of alignment of an optical axis can be obtained.

Also, the translucent member and the optical lens are attached to the side of the reinforcing plate, and the optical lens and the solid-state imaging element substrate can be aligned using a hole for positioning as a common reference from the front and the back. In addition, this hole may not be a through hole or may be a notch.

Also, in the embodiment described above, good imaging characteristics can be obtained by cutting an infrared region of light incident on the solid-state imaging element substrate when an optical filter is used as the translucent member.

Also, a thickness of the periphery of an opening part of the reinforcing plate in which the translucent member used in the solid-state imaging apparatus of the invention is placed may become thinner than the periphery. As a result of that, a positional deviation of the translucent member is eliminated and expansion of an adhesive for placement can also be suppressed.

In addition, it goes without saying that there is a necessity to align the solid-state imaging element substrate with the optical lens, and it is also important to align the translucent member with the solid-state imaging element substrate. This reason will be described.

Light emitted from the optical lens is designed to expand toward the solid-state imaging element substrate and it is constructed so as to emit the light from an exit pupil position exactly. As a result of this, a size of an optical filter constructed of the translucent member 14 requires a dimension in which an adhesion part is added to an opening of a plate-shaped member. Also, in a filter, a uniform film is formed in a vapor deposition apparatus, so that a work size (plate material before division) is limited and the work size is about 70 mm in angular size. Then, dicing and division is made by a diamond blade etc. in the case of forming products from the work size, so that a cost is determined by, that is, the number of products obtained from the work size. Hence, the cost can be reduced by minimizing a size including an adhesion area. Also, when a large filter is used, a solid-state imaging element overlaps with the filter in a plane. The center of the solid-state imaging element is called an effective imaging area and is a region in which light is actually photoelectrically converted into an electrical signal by a phototransistor (Tr), and there are a peripheral circuit etc. in the outside of this effective area and an electrode for wiring is disposed in its outside. Therefore, when the optical filter overlaps with a wiring part, the optical filter and the wiring part are respectively arranged in a thickness direction (optical axis direction), so that the thickness becomes thick. From the above standpoint, it is desirable to use a small filter in order to achieve thinning and cost reduction and therefore, accuracy of the translucent member is required in order to surely cover an effective range of a light beam as described above.

Also, a light blocking film may be formed on a back surface of the solid-state imaging element substrate used in the solid-state imaging apparatus as described above, with the result that occurrence of noise by transmission of light from the back surface can be avoided in the case of a thin solid-state imaging element substrate.

This light blocking film may be a metal film formed on a back surface of the solid-state imaging element substrate. By this configuration, light from the back surface can be blocked more surely in a thin type.

Also, this light blocking film may be a light blocking resin film formed on a back surface of the solid-state imaging element substrate. By this configuration, formation is easy and light from the back surface can be blocked surely.

### (Sixteenth embodiment)

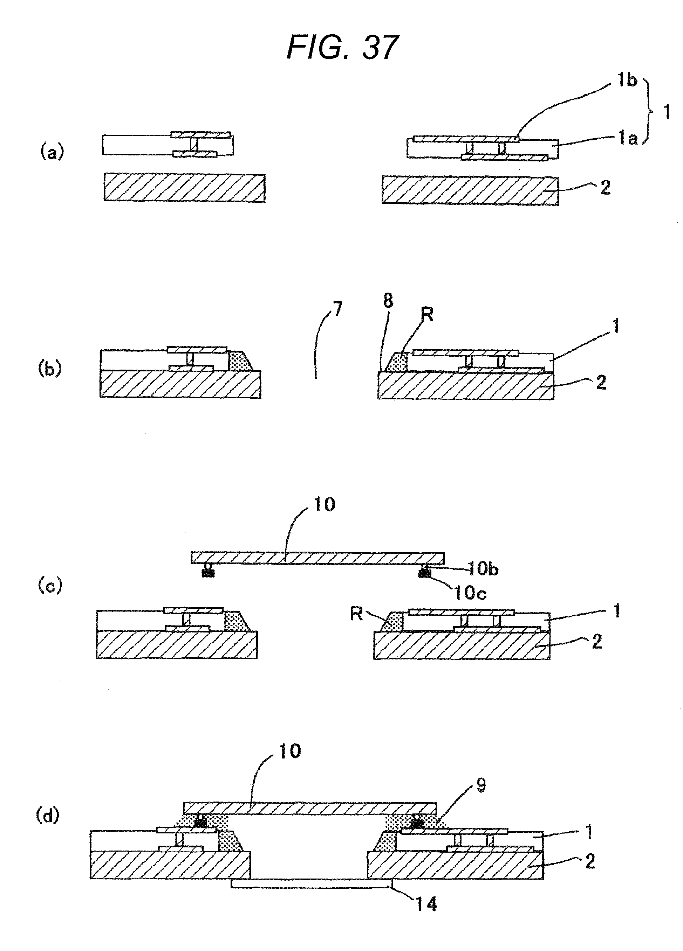

Next, a manufacturing method of the solid-state imaging apparatus shown in Fig. 31 will be described as a sixteenth embodiment of the invention. Fig. 37 is a step diagram showing a manufacturing method of the solid-state imaging apparatus of the sixteenth embodiment.

As shown in Fig. 37(a), vias were bored in a flexible base substance 1 a as a flexible wiring board 1, and wiring made of metal wiring patterns 1 b was formed on both surfaces and subsequently, lamination and integration with a reinforcing plate 2 were performed by an adhesive (not shown). A polyimide film with a thickness of 25 µm was used in the flexible wiring board 1 and a SUS plate with a thickness of 150 µm was used in the reinforcing plate 2. In the case of sticking the flexible wiring board 1 on the reinforcing plate 2, adhesion was performed using a conductive adhesive (not shown). As a result, a ground part of the metal wiring pattern 1b is electrically connected to the reinforcing plate 2 using the SUS plate. An insulating film (not shown) is formed on a surface of the wiring pattern which does not want to be grounded in the side of the reinforcing plate 2.

As shown in Fig. 37(b), prior to attachment of a solid-state imaging element substrate 10 and a translucent member 14, a resin part R was applied to an end face part of the whole periphery of the side of an opening part 7 of the flexible wiring board reinforcing plate 21. As shown in Fig. 37(c), a bump 10b was formed on an electrode (not shown) of the solid-state imaging element substrate 10 and a conductive adhesive 10c was transferred and formed to the top of the bump. The bump 10b at this time was formed by a gold wire and a silver paste was used in the conductive adhesive 10c. Subsequently, as shown in Fig. 37(d), the solid-state imaging element substrate 10 was mounted on the metal wiring pattern 1b of the flexible wiring board 1 and the conductive adhesive 10c was heated and cured. Further, after a sealing resin 9 was injected and was heated and cured, the translucent member 14 was opposed to the solid-state imaging element substrate 10 and was placed on the reinforcing plate 2. An infrared cut filter was used in the translucent member 14.

By adopting such a manufacturing method, occurrence of dust from an end face of the opening part 7 of the flexible wiring board 1 is suppressed and a solid-state imaging apparatus with no problem of image quality can be fabricated.

### (Seventeenth embodiment)

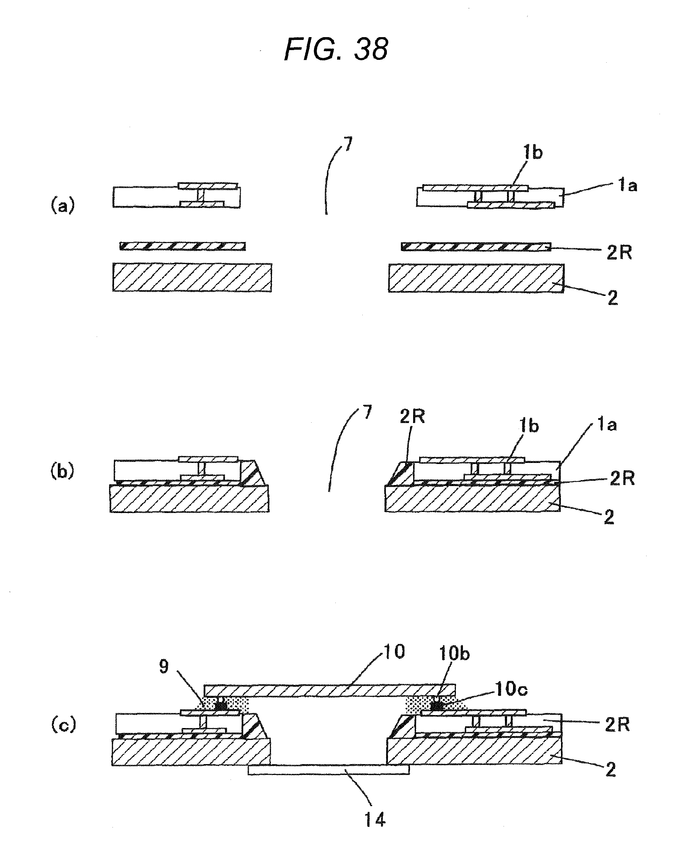

Fig. 38 is a step diagram showing a manufacturing method of the solid-state imaging apparatus of a seventeenth embodiment.

The embodiment is **characterized in that** a prepreg sheet 2R is arranged as a resin for pasting a flexible wiring board 1 on a reinforcing plate so as to reach an exposed part 8 of the reinforcing plate 2 and the edge of the flexible wiring board 1 is covered with this prepreg sheet 2R through a fastening step by heating and curing.

As shown in Fig. 38(a), a wiring board in which wiring of metal wiring patterns 1b of both surfaces connected through vias was formed in the flexible wiring board 1, the reinforcing plate 2 and the prepreg sheet 2R in which a resin was partially cured to a B stage were prepared. A polyimide film with a thickness of 25 µm was used in the flexible wiring board 1 and a SUS plate with a thickness of 150 µm was used in the reinforcing plate 2 and an epoxy resin sheet with a thickness of 9 µm was used in the prepreg sheet 2R. At this time, as shown in Fig. 38(a), an area of an opening part 7 of the prepreg sheet 2R was made larger than an opening part area of the flexible wiring board 1 and was made smaller than an opening part area of the reinforcing plate 2.

Subsequently, the flexible wiring board 1, the prepreg sheet 2R and the reinforcing plate 2 were laminated and a hot press was performed for one hour at 200 °C. As a result of this, the prepreg sheet 2R was melted and cured and the flexible wiring board 1 was glued to the reinforcing plate 2 and the flexible wiring board 1 was laminated and integrated with the reinforcing plate 2. Then, the portion in which the prepreg sheet 2R protruded from the flexible wiring board 1 to the opening part 7 was melted and cured in a state of covering an opening part side end face of the flexible wiring board 1.

Further, as shown in Fig. 38(c), a bump 10b was formed on an electrode (not shown) of a solid-state imaging element substrate 10 and a conductive adhesive 10c was transferred and formed to the top of the bump and the solid-state imaging element substrate 10 was mounted on the metal wiring pattern 1b of the flexible wiring board 1 and the conductive adhesive 10c was heated and cured and a sealing resin 9 was injected and heated and cured. Finally, a translucent member 14 was opposed to the solid-state imaging element substrate 10 and was placed on the reinforcing plate 2. The bump 10b at this time was formed by a gold wire and a silver paste was used in the conductive adhesive 10c and an infrared cut filter was used in the translucent member 14.

By adopting this manufacturing method, in a manner similar to the sixteenth embodiment, a solid-state imaging apparatus with a structure of suppressing occurrence of dust from an opening part end face of the flexible wiring board 1 can be fabricated and also, an end face can be covered simultaneously at the time of laminating and integrating the flexible wiring board 1 and the reinforcing plate 2 without separately preparing a resin for covering the opening part end face.

### (Eighteenth embodiment)

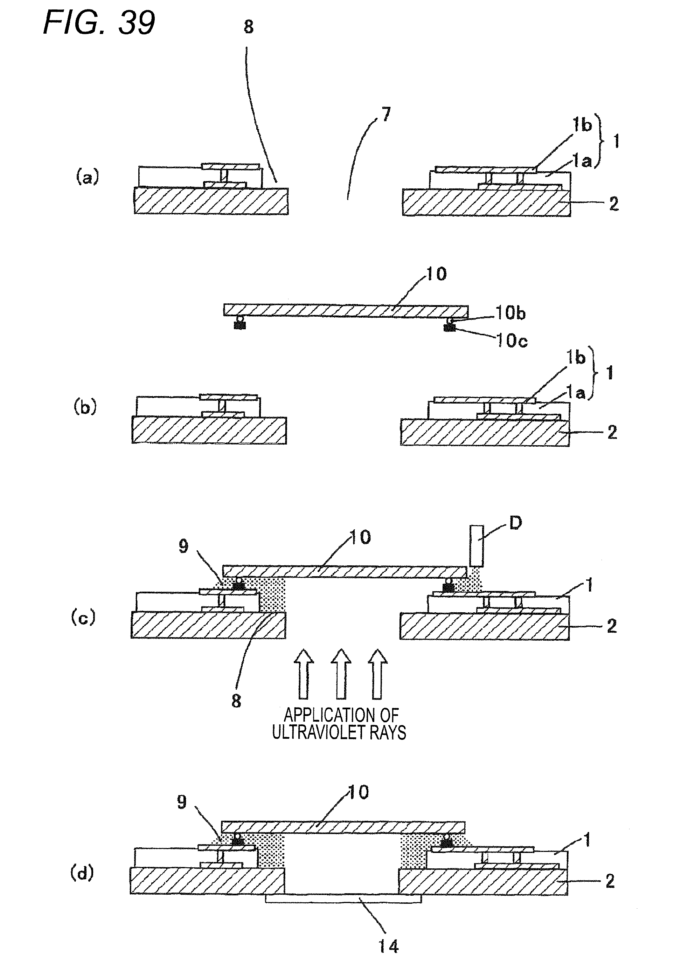

Fig. 39 is a step diagram showing a manufacturing method of a solid-state imaging apparatus of an eighteenth embodiment.

As shown in Fig. 39(a), a wiring board in which wiring of metal wiring patterns 1 b is formed on both surfaces through vias in a flexible wiring board 1, and a reinforcing plate 2 were laminated and integrated. A polyimide film with a thickness of 25 µm was used in the flexible wiring board 1 and a SUS plate with a thickness of 150 µm was used in the reinforcing plate 2. At this time, an area of an opening part 7 of the flexible wiring board 1 was made larger than an area of an opening part of the reinforcing plate 2 and an opening step part 8 was ensured.

Subsequently, as shown in Fig. 39(b), a bump 10b was formed on an electrode (not shown) of a solid-state imaging element substrate 10 and a conductive adhesive 10c was transferred and formed to the top of the bump and the solid-state imaging element substrate 10 was mounted on the metal wiring pattern 1b of the flexible wiring board 1 and the conductive adhesive 10c was heated and cured. The bump 10b at this time was formed by a gold wire and a silver paste was used in the conductive adhesive 10c.

Further, as shown in Fig. 39(c), a sealing resin 9 was injected using a dispenser D. At this time, the sealing resin 9 was moved into the opening step part 8 of the reinforcing plate 2 and the flexible wiring board 1. An ultraviolet curable epoxy resin was used as the sealing resin at this time. Then, ultraviolet rays were simultaneously applied from an opening part of the side of the reinforcing plate 2 during the injection of the sealing resin. As a result, while the sealing resin 9 protruded from the opening step part 8, ultraviolet curing was caused and a bonding part of the solid-state imaging element substrate 10 was reinforced without interrupting an imaging area of the solid-state imaging element substrate 10 and an opening end face part of the flexible wiring board 1 could be covered over. Thereafter, the portion to which the ultraviolet rays were not applied was heated and cured.

Finally, a translucent member 14 was fastened on the reinforcing plate 2 as opposed to the solid-state imaging element substrate 10. At this time, an infrared cut filter was used in the translucent member 14.

By adopting this method, in a manner similar to the sixteenth embodiment, a solid-state imaging apparatus with a structure of suppressing occurrence of dust from an opening part end face of the flexible wiring board 1 can be fabricated and also, an end face can be covered simultaneously in a step of mounting the solid-state imaging element substrate 10 without separately preparing a resin for covering the opening part end face.

### (Nineteenth embodiment)

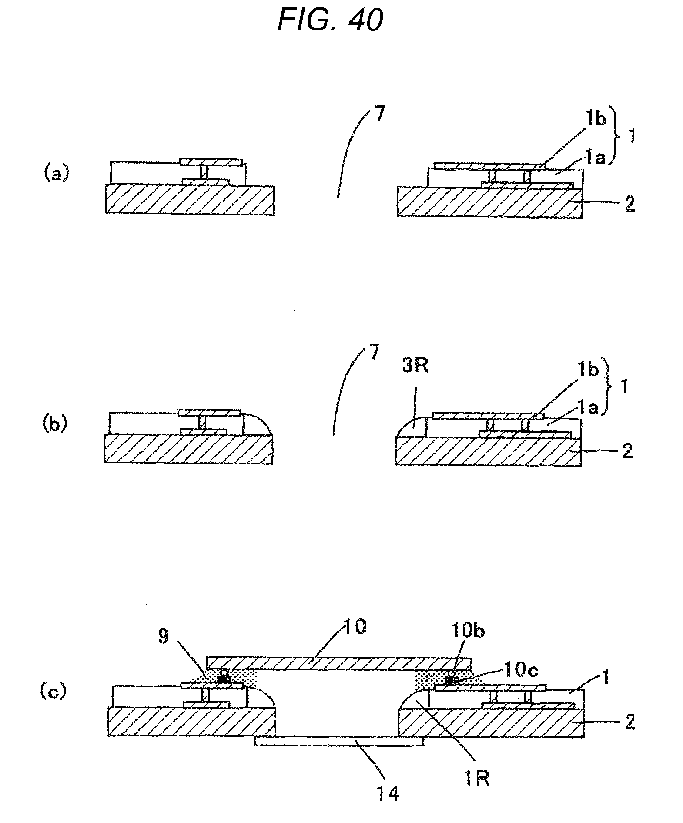

Fig. 40 is a step diagram showing a manufacturing method of a solid-state imaging apparatus of a nineteenth embodiment.

The embodiment is **characterized in that** in a step of performing end face processing, an end face facing an opening part of a flexible wiring board is locally heated and melted.

As shown in Fig. 40(a), vias were bored in a flexible wiring board 1, and wiring of metal wiring patterns 1b was formed on both surfaces and subsequently, lamination and integration with a reinforcing plate 2 were performed by an adhesive (not shown). A polyimide film with a thickness of 25 µm was used in the flexible wiring board 1 and a SUS plate with a thickness of 150 µm was used in the reinforcing plate 2.

Subsequently, as shown in Fig. 40(b), a resin end part 3R was formed by again melting an end face part of the flexible wiring board 1 by a local heater (not shown) in the end face part of the whole periphery of the side of an opening part 7 of the flexible wiring board 1. Since this resin end part 3R was again melted, exposure of an end face of a film base substance 1 a could be eliminated.

Further, as shown in Fig. 40(c), a bump 10b was formed on an electrode (not shown) of a solid-state imaging element substrate 10 and a conductive adhesive 10c was transferred and formed to the top of the bump and the solid-state imaging element substrate 10 was mounted on the metal wiring pattern 1b of the flexible wiring board 1 and the conductive adhesive 10c was heated and cured and a sealing resin 9 was injected and heated and cured. Finally, a translucent member 14 was opposed to the solid-state imaging element substrate 10 and was placed on the reinforcing plate 2. The bump 10b at this time was formed by a gold wire and a silver paste was used in the conductive adhesive 10c and an infrared cut filter was used in the translucent member 14.

By adopting this method, in a manner similar to the sixteenth embodiment, a solid-state imaging apparatus with a structure capable of suppressing occurrence of dust from an opening part end face of the flexible wiring board 1 can be fabricated without separately preparing a resin for covering the opening part end face.

In addition, it may be constructed so as to form an opening part in a flexible wiring board on a processing condition that the peripheral edge of a cut line melts after a reinforcing plate is stuck on the flexible wiring board in a step of forming a laminated body.

According to this configuration, by melting and cutting the peripheral edge by, for example, laser processing, the cut edge has a melt end face and dust hardly occurs. In this case, occurrence of dust at the time of processing can also be reduced, so that reliability can be improved more.

The invention described in the fifteenth to nineteenth embodiments has the following aspect.

A solid-state imaging apparatus of the invention comprises a flexible wiring board having an opening part, a reinforcing plate laminated and fastened to the flexible wiring board, a translucent member and a solid-state imaging element substrate attached to the flexible wiring board, and is **characterized in that** at least a part of an end face of the opening part of the flexible wiring board is covered with a resin.

This configuration is **characterized in that** at least a part of an end face of the opening part of the flexible wiring board is covered with a resin. As a result of that, the solid-state imaging apparatus is thin but has high rigidity, and occurrence of dust from an opening part end face of the flexible wiring board can be suppressed.

Also, in the solid-state imaging apparatus of the invention, a resin with which the end face of the opening part of the flexible wiring board is covered may be the same as an adhesive by which lamination and integration with a reinforcing plate are performed. As a result of that, a material can be shared in addition to the previous dust suppression effect.

Also, in the solid-state imaging apparatus of the invention, a resin with which the end face of the opening part of the flexible wiring board is covered may be the same as a sealing resin at the time of placing a solid-state imaging element substrate. As a result of that, a material can be shared in addition to the previous dust suppression effect.

Also, the solid-state imaging apparatus of the invention may be constructed so that the translucent member and an optical lens are attached to the side of the reinforcing plate and the optical lens and the solid-state imaging element substrate are aligned using a reference hole formed in the laminated substrate as a common reference from the front and the back. By this configuration, position accuracy can be improved.

Also, the solid-state imaging apparatus of the invention is a solid-state imaging apparatus comprising a flexible wiring board having an opening part, a reinforcing plate having an opening part, a solid-state imaging element substrate and a translucent member, and is **characterized in that** the flexible wiring board and the reinforcing plate are laminated and integrated and melting and curing treatment of the end of the opening part of the flexible wiring board is performed and at least a part of the end face is not bare. As a result of that, the solid-state imaging apparatus is thin but has high rigidity, and has an effect capable of suppressing occurrence of dust from an opening part end face of the flexible wiring board without adding an excessive material.

An optical filter may be used as the translucent member used in the solid-state imaging apparatus of the invention. As a result of that, good imaging characteristics can be obtained by cutting an infrared region of light incident on a solid-state imaging element substrate.

Also, a metal plate may be used as the reinforcing plate used in the solid-state imaging apparatus of the invention. As a result of that, high rigidity of the solid-state imaging apparatus can be obtained.

Also, the metal reinforcing plate may be electrically connected to a ground part of a wiring pattern of the flexible wiring board used in the solid-state imaging apparatus of the invention. As a result of that, stability of electrical characteristics can be obtained.

Also, in the solid-state imaging apparatus of the invention, an electrical path for fetching an electrical signal from the flexible wiring board by a connector or a wiring substrate may be ensured. As a result of that, a video signal of a solid-state imaging element substrate can effectively be fetched to the outside in a state of decreasing the flexible wiring board and the reinforcing plate to the necessary minimum.

Also, in the solid-state imaging apparatus of the invention, a chip component may be installed on the flexible wiring board. As a result of that, freedom of electrical wiring design improves and the chip component can be placed in the vicinity of a solid-state imaging element substrate and electrical characteristics can be optimized.

Also, a manufacturing method of a solid-state imaging apparatus of the invention is characterized by comprising the steps of sticking a flexible wiring board on a reinforcing plate and forming a laminated body having a through opening part, performing end face processing so as to cover an end face of an opening part of the flexible wiring board, installing a solid-state imaging element substrate so as to close the opening part of the flexible substrate, and installing a translucent member so as to close an opening part of the reinforcing plate.

According to this method, an opening part end face of the flexible wiring board can be covered surely as a result, and occurrence of dust from the end face can be suppressed.

Also, in the manufacturing method of the solid-state imaging apparatus described above, the invention is **characterized in that** the step of performing end face processing includes a step of forming a resin part so as to cover an end face of an opening part of the flexible wiring board.

Also, in the manufacturing method of the solid-state imaging apparatus described above, the invention is **characterized in that** the step of performing end face processing includes a step of thermally curing and forming an opening part end face so as to cover the opening part end face by protruding an adhesive used in the sticking step beyond the opening part end face.

According to this configuration, without adding an excessive resin material and also increasing an excessive step, an opening part end face of the flexible wiring board can be covered and occurrence of dust from the end face can be suppressed.

Also, a manufacturing method of a solid-state imaging apparatus of the invention comprises the steps of sticking a flexible wiring board on a reinforcing plate, installing a solid-state imaging element substrate so as to close an opening part of the flexible substrate, and installing a translucent member so as to close an opening part of the reinforcing plate, and is **characterized in that** a method for installing the solid-state imaging element substrate is a mounting method in which after a bump is formed in a wiring part of the solid-state imaging element substrate, a conductive adhesive is transferred to the bump and flip chip mounting is performed in a flexible substrate and electrical bonding is ensured by thermal curing and a sealing resin is injected from the periphery of a bonding part to an opening part end face of the flexible wiring board. As a result, without adding an excessive resin material and also increasing an excessive step, the opening part end face of the flexible wiring board can be covered in a manufacturing step and occurrence of dust from the end face can be suppressed.

Also, in the manufacturing method of the solid-state imaging apparatus described above, the invention is **characterized in that** the step of performing end face processing includes a step of locally heating and melting an end face facing the opening part of the flexible wiring board.

That is, it is characterized by comprising the steps of sticking a flexible wiring board having an opening part on a reinforcing plate having an opening part, melting a resin by locally applying heat to only an end face of the opening part of the flexible wiring board, installing a solid-state imaging element substrate so as to close the opening part of the flexible substrate, and installing a translucent member so as to close the opening part of the reinforcing plate. As a result, without adding an excessive resin material, an opening part end face of the flexible wiring board can be covered and occurrence of dust from the end face can be suppressed.

By using the solid-state imaging apparatus of the invention and the manufacturing method thereof thus, the solid-state imaging apparatus can be thinned and high rigidity and a reduction in a defect in dust can be achieved simply, so that the solid-state imaging apparatus with high reliability and a high yield can be manufactured. As a result of that, a portable terminal apparatus can also be thinned.

Also, in the manufacturing method of the solid-state imaging apparatus described above, the invention is **characterized in that** the step of forming the laminated body includes a step of forming an opening part in a flexible wiring board on a processing condition that the peripheral edge of a cut line melts after a reinforcing plate is stuck on the flexible wiring board.

According to this configuration, by melting and cutting the peripheral edge by, for example, laser processing, the cut edge has a melt end face and dust hardly occurs.

According to the configuration described above, a flexible wiring board having an opening part and a reinforcing plate having an opening part are laminated and integrated and at least a part of an end face of the opening part of the flexible wiring board is covered with a resin, so that dust occurring inside the opening part can be suppressed. Also, the reinforcing plate is laminated, so that it is easy to thin a solid-state imaging apparatus and the apparatus can have high rigidity. As a result of that, a mobile telephone etc. can be miniaturized and an excellent solid-state imaging apparatus with a less dust defect can be provided. The solid-state imaging apparatus can be thinned and the solid-state imaging apparatus having high rigidity and low dust defect properties and the manufacturing method thereof can be provided simply.

### <Industrial Applicability>

As described above, in a solid-state imaging apparatus of the invention and the manufacturing method thereof, the solid-state imaging apparatus can be thinned and high rigidity and improvements in accuracy and reliability can be achieved simply, so that it is useful for application to a miniature portable terminal such as a mobile telephone.

## Claims

1. A solid-state imaging apparatus, comprising:
a laminated substrate constructed of a flexible wiring board having an opening part and a reinforcing plate laminated and integrated with the flexible wiring board,
a translucent member placed in the side of the reinforcing plate of the laminated substrate so as to close an opening part, and
a solid-state imaging element substrate placed in the side of the flexible wiring board of the laminated substrate, wherein the reinforcing plate comprises a reference hole for solid-state imaging element substrate placement, and the reinforcing plate is also exposed to the side of the flexible wiring board in the peripheral edge of the reference hole and a solid-state imaging element substrate and a translucent member are arranged on both surfaces of the laminated substrate using the reference hole as a common reference.

2. The solid-state imaging apparatus as claimed in claim 1, comprising a second flexible wiring board bonded to the flexible wiring board.

3. The solid-state imaging apparatus as claimed in claim 2, comprising a resin molded part with which a bonding part between the flexible wiring board and the second flexible wiring board is covered.

4. The solid-state imaging apparatus as claimed in claim 3, wherein a component is installed on the flexible wiring board and the resin molded part is formed so as to cover the component.

5. The solid-state imaging apparatus as claimed in claim 2, comprising a reinforcing adhesion part with which the periphery of a bonding part is covered from the reinforcing plate to the second flexible wiring board.

6. The solid-state imaging apparatus as claimed in claim 1, wherein at least a part of an end face of the opening part of the flexible wiring board is covered with a resin.

7. The solid-state imaging apparatus as claimed in claim 6, wherein a resin with which an end face of an opening part of the flexible wiring board is covered is the same resin as an adhesive by which a reinforcing plate is laminated and integrated with the flexible wiring board.

8. The solid-state imaging apparatus as claimed in claim 6, wherein a resin with which an end face of an opening part of the flexible wiring board is covered is the same resin as a sealing resin at the time of placing the solid-state imaging element substrate.

9. The solid-state imaging apparatus as in any of claims 1-8, wherein the translucent member and an optical lens are attached to the side of the reinforcing plate, and the optical lens and the solid-state imaging element substrate are aligned using the reference hole as a common reference from the front and the back.

10. The solid-state imaging apparatus as in any of claims 1-9, wherein the translucent member is an optical filter.

11. The solid-state imaging apparatus as in any of claims 1-10, wherein the reinforcing plate is a metal plate.

12. The solid-state imaging apparatus as claimed in claim 11, wherein a ground part of a wiring pattern of the flexible wiring board is electrically connected to the reinforcing plate.

13. The solid-state imaging apparatus as in any of claims 1-12, wherein a thickness of the periphery of an opening part of the reinforcing plate in which the translucent member is placed becomes thinner than the periphery and a thin-wall part is constructed.

14. The solid-state imaging apparatus as in any of claims 1-13, wherein a connector is mounted on a wiring pattern of the flexible wiring board.

15. The solid-state imaging apparatus as in any of claims 1-14, wherein a chip component is installed on a wiring pattern of the flexible wiring board.

16. The solid-state imaging apparatus as in any of claims 1-15, wherein resin molding is performed on a back surface of the solid-state imaging element substrate.

17. The solid-state imaging apparatus as in any of claims 1-16, wherein a light blocking film is formed on a back surface of the solid-state imaging element substrate.

18. The solid-state imaging apparatus as claimed in claim 17, wherein the light blocking film is a metal film formed on a back surface of the solid-state imaging element substrate.

19. The solid-state imaging apparatus as claimed in claim 17, wherein the light blocking film is a light blocking resin film formed on a back surface of the solid-state imaging element substrate.

20. The manufacturing method of a solid-state imaging element, comprising the steps of:
sticking a flexible wiring board on a reinforcing plate and forming a laminated body having a through opening part,
cutting an outer shape of the laminated body,
partially removing the flexible wiring board and forming a reference hole so as to reach the reinforcing plate,
installing a solid-state imaging element substrate so as to close an opening part of the flexible substrate using the reference hole as a reference, and
installing a translucent member so as to close an opening part of the reinforcing plate.

21. The manufacturing method of a solid-state imaging apparatus as claimed in claim 20, further including a step of being positioned from the outside of the translucent member using the reference hole as a reference and installing a lens cabinet in which an optical lens is installed in the reinforcing plate.

22. The manufacturing method of a solid-state imaging apparatus as claimed in claim 20 or 21, wherein a step of forming the laminated body includes a step of forming a through opening part after a flexible wiring board is stuck on a reinforcing plate.

23. The manufacturing method of a solid-state imaging apparatus as claimed in claim 20 or 21, wherein a step of forming the laminated body includes a step of aligning a flexible wiring board comprising an opening part with a reinforcing plate comprising an opening part so that the opening parts coincide with each other and a step of sticking the flexible wiring board on the reinforcing plate.

24. The manufacturing method of a solid-state imaging apparatus as claimed in claim 23, wherein a step of performing the alignment includes a step of performing alignment so as to expose the peripheral edge of an opening part of the reinforcing plate from an opening part of the flexible substrate.

25. The manufacturing method of a solid-state imaging apparatus as claimed in claim 20, wherein a step of forming a reference hole or a notched part includes a step of etching a flexible wiring board and a reinforcing plate.

26. The manufacturing method of a solid-state imaging apparatus as claimed in claim 20, wherein a step of installing a solid-state imaging element substrate includes a step of forming a conductive adhesive layer in a bump of the solid-state imaging element substrate and performing flip chip mounting in a flexible substrate and injecting a sealing resin into the periphery of a bonding part.
